(19) Europäisches Patentamt
European Patent Office
Office européen des brevets

(11) **EP 1 554 803 B1**

(12) **EUROPÄISCHE PATENTSCHRIFT**

(45) Veröffentlichungstag und Bekanntmachung des Hinweises auf die Patenterteilung:
**05.07.2006 Patentblatt 2006/27**

(51) Int Cl.:
*H03K 5/135* (2006.01)   *H03L 7/00* (2006.01)

(21) Anmeldenummer: **03785629.1**

(22) Anmeldetag: **17.10.2003**

(86) Internationale Anmeldenummer:
**PCT/EP2003/011558**

(87) Internationale Veröffentlichungsnummer:
**WO 2004/038918 (06.05.2004 Gazette 2004/19)**

(54) **VERFAHREN UND VORRICHTUNG ZUM ERZEUGEN EINES TAKTSIGNALS MIT VORBESTIMMTEN TAKTSIGNALEIGENSCHAFTEN**

METHOD AND DEVICE FOR GENERATING A CLOCK SIGNAL WITH PREDETERMINED CLOCK SIGNAL PROPERTIES

PROCEDE ET DISPOSITIF POUR PRODUIRE UN SIGNAL D'HORLOGE AUX PROPRIETES PREDETERMINEES

(84) Benannte Vertragsstaaten:
**DE GB**

(30) Priorität: **25.10.2002 DE 10249886**

(43) Veröffentlichungstag der Anmeldung:
**20.07.2005 Patentblatt 2005/29**

(73) Patentinhaber:
 • **Koninklijke Philips Electronics N.V.
 5621 BA Eindhoven (NL)**
 • **Philips Intellectual Property & Standards GmbH
 20099 Hamburg (DE)**
 Benannte Vertragsstaaten:
 **DE**

(72) Erfinder: **FURTNER, Wolfgang
 82256 Fürstenfeldbruck (DE)**

(74) Vertreter: **Zimmermann, Tankred Klaus et al
 Schoppe, Zimmermann,
 Stöckeler & Zinkler
 Patentanwälte
 Postfach 246
 82043 Pullach bei München (DE)**

(56) Entgegenhaltungen:
 **US-A- 5 394 114       US-A- 5 786 715
 US-A- 6 031 401       US-A1- 2002 097 176**

 • **BAZES M ET AL: "AN INTERPOLATING CLOCK SYNTHESIZER" IEEE JOURNAL OF SOLID-STATE CIRCUITS, IEEE INC. NEW YORK, US, Bd. 31, Nr. 9, 1. September 1996 (1996-09-01), Seiten 1295-1301, XP000638070 ISSN: 0018-9200**

EP 1 554 803 B1

**Beschreibung**

Die vorliegende Erfindung bezieht sich auf ein System zur digitalen Synthese von verschiedenen unterschiedlichen Taktsignalen (DCS = Digital Clock Synthesis), und insbesondere auf ein Verfahren und eine Vorrichtung zum Erzeugen eines Taktsignals mit vorbestimmten Taktsignaleigenschaften, und hier insbesondere auf ein Verfahren und auf eine Vorrichtung zum Erzeugen eines Taktsignals mit nahezu einer beliebigen Frequenz und einem beliebigen Tastverhältnis.

Traditionell werden unabhängige Taktsignale mittels der bekannten analogen Taktsynthese erzeugt, wobei herkömmlicherweise eine Mehrzahl von PLLs (PLL = Phase Locked Loop = Phasenregelschleife) verwendet werden. Solche herkömmlichen Ansätze sind nachteilhaft, da hier der gesamte Jitter-Beitrag (Zitter-Beitrag) hoch ist, und die Taktgenauigkeit beschränkt ist, da herkömmliche analoge PLLs auf diskrete Frequenzen beschränkt sind, welche durch die PLL-Teilerelemente zugelassen sind. Ein weiterer Nachteil herkömmlicher Ansätze besteht darin, dass die verwendeten analogen Schaltungen einer Vielzahl von Schaltungsblöcken bedürfen, so dass die Schaltungskomplexität hoch ist. Ferner ist die Anzahl der auf einem einzelnen Chip zu realisierenden PLLs beschränkt, und damit auch die Anzahl der verfügbaren unabhängigen Taktsignale. Wiederum ein weiterer Nachteil herkömmlicher Ansätze besteht darin, dass für jede der PLLs, die bei herkömmlichen, analogen Ansätzen verwendet werden, eine zugeordnete externe analoge Leistungsversorgung bereitgestellt werden muss. Der Entwurfsaufwand für die analogen Schaltungen ist hoch.

Die EP 1 137 188 A2 beschreibt eine digitale PLL bei der nur einzelne Pulse eines Multiphasen-Clocks ausgewählt werden, die ein Toggel-Flipflop ansteuern, dass dann einen Clock mit 50% Tastverhältnis (duty cycle) generiert. Es wird ein 'traditioneller' PLL Regelkreis mit einem digitalem Phasenkomparator verwendet. Der Phasenvergleich Sync/synth.Sync bewirkt ein iteratives Nachregeln von Phase und Frequenz des Abtasttakts (Sample Clock). Es ist nicht möglich (mehrere) Takte mit binär programmierbarer Frequenz, Duty Cycle und Phase mit beliebiger Genauigkeit (also auch nicht ganzzahlige) Vielfache eines Sync-Clocks zu erzeugen.

Die US-A-6,031,401 beschreibt einen Taktsignalsynthetisierer, der ein Zeitsignal erzeugt, das ein mehrfaches der Frequenz eines Mastertaktsignals ist. Der Synthetisierer kann die ansteigenden und abfallenden Flanken des synthetisierten Signalverlaufs innerhalb der Periode des Mastertaktsignals programmierbar einstellen. Der Synthetisierer hat eine Verzögerungsleitung mit mehreren Abgriffen, die Wiederholungen des Mastertaktsignals erzeugen werden, die gegenüber dem Mastertaktsignal inkremental verzögert sind. Ein Teil der Verzögerungssignale wird als Eingangssignal an jeden einer Mehrzahl von Multiplexern bereitgestellt, wobei abhängig von einem Auswahlsignal ein Verzögerungssignal ausgewählt wird. Die ausgewählten Verzögerungssignale werden als Eingangssignale an Flip-Flop-Schaltungen weitergegeben, deren Ausgänge mit einer Kombinationslogik verbunden sind, die die Signale von den Ausgängen der verschiedenen Flip-Flop-Schaltungen verbinden wird, um das synthetisierte Zeitsignal zu erzeugen.

Die US-A-5,394,114 beschreibt einen programmierbaren Signalgenerator mit einer Auflösung von einer Nanosekunde. Der Generator erzeugt ein Taktsignal, das eine Frequenz, eine Phasenverschiebung und einen Tastzyklus aufweist, der relativ zu einem periodischen Referenzsignal ist. Hierfür werden die Ausgangssignale eines spannungsgesteuerten Ringoszillators direkt verwendet, um die Eingänge eines programmierbaren Logikgatters zu treiben, um Pulse zu erzeugen. Die Phasenverschiebung hat eine Auflösung von einer Nanosekunde. Zusätzlich können die erzeugten Pulse logisch verknüpft werden, um Taktsignale mit einem Mehrfachen der Eingangsfrequenz zu erzeugen.

Der vorliegenden Erfindung liegt die Aufgabe zugrunde, ein verbessertes Verfahren und eine verbesserte Vorrichtung zum Erzeugen eines Taktsignals mit vorbestimmten Taktsignaleigenschaften zu schaffen, welche die oben beschriebenen Nachteile im Stand der Technik vermeiden.

Diese Aufgabe wird durch ein Verfahren nach Anspruch 1 und durch eine Vorrichtung nach Anspruch 14 gelöst.

Die vorliegende Erfindung schafft ein Verfahren zum Erzeugen eines Taktsignals mit vorbestimmten Taktsignaleigenschaften, mit folgenden Schritten:

(a) Bereitstellen einer Mehrzahl von Taktsignalen mit im wesentlichen gleicher Frequenz und jeweils verschiedenen Phasenbeziehungen bezüglich eines Mastertaktsignals; und

(b) basierend auf einem Steuersignal, das abhängig von dem zu erzeugenden Taktsignal bereitgestellt wird, Auswählen vorbestimmter Taktsignale aus der Mehrzahl von bereitgestellten Taktsignalen und Zusammenfassen der ausgewählten Taktsignale, um das Taktsignal zu erzeugen,

wobei das Steuersignal eine Mehrzahl von Aktivierungssignalen (PEN[n-1:0]) umfasst, wobei ein Aktivierungssignal (PEN[]) für jedes der Mehrzahl von Taktsignalen (PCLK[]) vorgesehen ist, und wobei die Aktivierungssignale (PEN[]) verzögert bereitgestellt werden, um eine Ausrichtung derselben einzustellen, um die vorbestimmten Taktsignaleigenschaften des zu erzeugenden Taktsignals (CLKOUT) zu erhalten.

Die vorliegende Erfindung schafft ferner eine Vorrichtung zum Erzeugen eines Taktsignals mit vorbestimmten Taktsignaleigenschaften, mit

einem Multi-Phasen-Taktgenerator zum Bereitstellen einer Mehrzahl von Taktsignalen mit im wesentlichen gleicher Frequenz und jeweils verschiedener Phasenbeziehungen bezüglich eines Mastertaktsignals; und

einer Phasenüberlagerungseinheit, die basierend auf einem Steuersignal, das abhängig von dem zu erzeugenden Taktsignal bereitgestellt wird, vorbestimmte Taktsignale aus der Mehrzahl von bereitgestellten Taktsignalen auswählt und die ausgewählten Taktsignale zusammenfasst, um das Taktsignal zu erzeugen,

wobei das Steuersignal eine Mehrzahl von Aktivierungssignalen (PEN[n-1:0]) umfasst, wobei ein Aktivierungssignal (PEN[]) für jedes der Mehrzahl von Taktsignalen (PCLK[]) vorgesehen ist, und wobei die Aktivierungssignale (PEN[]) verzögert bereitgestellt werden, um eine Ausrichtung derselben einzustellen, um die vorbestimmten Taktsignaleigenschaften des zu erzeugenden Taktsignals (CLKOUT) zu erhalten.

Gemäß einem bevorzugten Ausführungsbeispiel der vorliegenden Erfindung werden beim Zusammenfassen der ausgewählten Taktsignale die Pulse mit hohem logischen Pegel der ausgewählten Taktsignale zusammengefasst, um das Taktsignal mit einem Puls mit hohem logischen Pegel und einer vorbestimmten Pulsdauer zu erzeugen. Mittels des bereitgestellten Steuersignals wird die Dauer der einzelnen Pulse mit hohem logischen Pegel, die Dauer der einzelnen Pulse mit niedrigem logischen Pegel und die Form des Pulszuges des zu erzeugenden Taktsignals gesteuert. Die kürzeste Dauer eines Pulses mit hohem logischen Pegel ist hier für die Dauer des Pulses mit hohem logischen Pegel des Mastertaktsignals festgelegt, und die kürzeste Dauer eines Pulses mit niedrigem logischen Pegel ist durch die erreichte Phasenauflösung bestimmt .

Vorzugsweise umfasst das Steuersignal eine Mehrzahl von Aktivierungssignalen, wobei ein Aktivierungssignal für jedes der Mehrzahl von Taktsignalen vorgesehen ist, und wobei die Aktivierungssignale verzögert bereitgestellt werden, um eine Ausrichtung derselben einzustellen, um die vorbestimmten Taktsignaleigenschaften des zu erzeugenden Taktsignals sicherzustellen. Vorzugsweise werden die Aktivierungssignale in Form einer Aktivierungssignalsequenz bereitgestellt, um ein periodisches Taktsignal mit vorbestimmter Frequenz und vorbestimmtem Tastverhältnis zu erzeugen. Die Aktivierungssequenz wird unter Verwendung eines primären Flankeninterpolartors, eines sekundären Flankenberechners sowie einer Phasenaktivierungseinheit erzeugt, wobei der primäre Flankeninterpolator einen Zeitpunkt bzw. eine temporäre Position (Zeitstempel) der führenden Flanken in dem zu erzeugenden Taktsignal bestimmt, wobei der sekundäre Flankenberechner einen Zeitpunkt der nachfolgenden Flanke in dem zu erzeugenden Taktsignal, ausgehend von dem Zeitpunkt der führenden Flanke, erzeugt, und wobei die Phasenaktivierungseinheit basierend auf dem Zeitpunkt der führenden Flanke und basierend auf dem Zeitpunkt der nachfolgenden Flanke die Aktivierungssignalsequenz erzeugt.

Ein Zeitstempel setzt sich durch eine fortlaufende Nummer eines Mastertaktzyklus und eines Subcycle-Zeitpunkts zusammen (ganzzahliges Vielfaches des Mastertakts + Bruchteil des Mastertakts).

Gemäß einem weiteren bevorzugten Ausführungsbeispiel der vorliegenden Erfindung werden synchronisierte Taktsignale erzeugt, wobei hier dem zu erzeugenden Taktsignal eine definierte Phasen- und Frequenzbeziehung zu dem Synchronisationssignal zugeordnet ist, wobei eine Flankenerfassungseinheit zusätzlich vorgesehen ist, um Signalzustandsänderungen in dem Synchronisationssignal zu erfassen, um ein Flankenmuster zu erzeugen. Mittels eines Flankenpositionsdecoders werden Flanken mit einer vorbestimmten Polarität, also ansteigende oder abfallende Flanken, in dem Flankenmuster bestimmt. Mittels eines Taktparameterberechners werden, basierend auf den bestimmten Flanken des Synchronisationssignals die Periode und die Phase für das zu erzeugende synchronisierte Taktsignal bestimmt, und anschließend wird unter Verwendung des primären Flankeninterpolators, des sekundären Flankenberechners sowie der Phasenaktivierungseinheit und der Phasenüberlagerungseinheit das synchronisierte Taktsignal erzeugt.

Gemäß einem weiteren bevorzugten Ausführungsbeispiel der vorliegenden Erfindung wird die Periode des erzeugten Taktsignals im spektralen Bereich moduliert, um ein Spreadspektrum Taktsignal zu erhalten, wobei mittels eines Spreadspektruminterpolators nach jedem erzeugten Taktsignalzyklus bewirkt wird, dass die erzeugte Periode um einen vorbestimmten Wert inkrementiert wird, bis eine obere Grenze erreicht ist. Anschließend wird bewirkt, dass die Periode um einen vorbestimmten Wert dekrementiert wird, bis eine untere Grenze erreicht ist. Dies wird zyklisch wiederholt

Gemäß einem weiteren bevorzugten Ausführungsbeispiel der vorliegenden Erfindung wird die Möglichkeit geschaffen, einen beliebigen Takt zu erzeugen (Arbitrary Clock Synthesis). Gemäß diesem allgemeineren Ansatz kann eine beliebige Anzahl von Takten von demselben Multiphasentaktsignal synthetisiert werden, wobei der Zeitverlauf des Taktausgangs von einer beliebigen Anzahl von Synchronisationssignalen abhängen kann. Bei diesem Ausführungsbeispiel ist ein Mastertaktzähler vorgesehen, der bei jedem Mastertaktzyklus inkrementiert wird, wodurch ein gemeinsames Zeitreferenzsystem gebildet wird. Durch Verwendung dieser Referenz können Zeitstempel jedem tatsächlichen oder auch jedem hypothetischen Ereignis (z.B. steigende oder fallende Flanke) in dem gesamten Takterzeugungssystem zugeordnet werden. Um die zeitliche Position des Ereignisses zwischen diskreten Mastertaktereignissen auszudrücken, können Bruchzahlen mit nahezu unbeschränkter Genauigkeit verwendet werden.

Zeitstempel werden steigenden Flanken und fallenden Flanken des externen Synchronisationsereignis zugeordnet, werden jedoch auch Flankenpositionen von potenziell komplexen und unregelmäßigen Taktsignalen zugeordnet. Der abstrakte Begriff "Zeitstempel" ermöglicht die arithmetische Verarbeitung der Ereignisse. Beliebige Taktformen können damit berechnet werden, und Taktsignale mit vorbestimmter Beziehung untereinander und zu externen Ereignissen können einfach erzeugt werden.

Erfindungsgemäß können basierend auf den im Schritt (a) bereitgestellten Taktsignalen auch eine Mehrzahl von unabhängigen Taktsignalen erzeugt werden.

Die vorliegende Erfindung schafft somit ein System für die digitale Synthese von verschiedenen unabhängigen Taktsignalen (DCS = Digital Clock Synthesis). Als gemeinsame Basis für alle synthetisierten Taktsignale werden mehrfache Phasen eines Taktsignals mit fester Frequenz verwendet. Erfindungsgemäß sind die auf diese Art und Weise synthetisierten Taktsignale erheblich stabiler als vergleichbare Taktsignale, die mittels einer traditionellen, analogen Taktsynthese erhalten wurden.

Gegenüber den oben beschriebenen, herkömmlichen Ansätzen ermöglicht das erfindungsgemäße Konzept der digitalen Taktsynthese (DCS) die Überlagerung der Takte um die gewünschten Taktpulse mit variablem Tastverhältnis (duty cycle) zu erzeugen. Anstelle des herkömmlichen Regelkreises wird erfindungsgemäß der Zeitpunkt des Sync-Events gemessen und mit einem nur 'virtuell' vorhandenem idealen Sync-Event verglichen. Erfindungsgemäß wird der Phasenfehler bei dem virtuellen Sync-Vergleich quantitativ genau bestimmt und der ideale Takt 'errechnet' und sofort generiert.

Das Konzept von universellen Zeitstempeln (Timestamps) das es möglich macht im ganzen System Events miteinander rein analytisch in Bezug zu setzen, fehlt im Stand der Technik. Auf den oben beschriebenen Ansatz mit einem herkömmlichen Regelkreis kann daher verzichtet werden.

Weitere Vorteile der vorliegenden Erfindung bestehen insbesondere bei Systemen auf einem Chip, welche mehrere Taktbereiche verwenden (Clock Domains). Überdies schafft die vorliegende Erfindung mit dem gleichen Ansatz auch synchronisierte Taktsignale, wobei insbesondere ein Takt für die Abtastung analoger Signale mit programmierbarem Taktverhältnis und programmierbarer Phasenbeziehung zu einem niederfrequenten Synchronisationssignal erzeugt werden kann.

Gemäß einem weiteren Vorteil der vorliegenden Erfindung werden mögliche Implementierungen der Technik in modularer Bauweise ermöglicht, wobei mittels eines Satzes von einfachen, standardisierten Modulen für die digitale Taktsynthese fast jede Anwendung bedient werden kann, wodurch sich ein sehr hoher Grad an Wiederverwendbarkeit ergibt.

Die erfindungsgemäße digitale Taktsynthese bietet eine Vielzahl von Vorteilen gegenüber der traditionellen analogen Taktsynthese.

- verbesserter Taktjitter: erfindungsgemäß kann ein Multiphasentakt mit fester Frequenz mit einem sehr niedrigen Jitter-Level erzeugt werden, so dass trotz des zusätzlichen Jitters, der durch die Phasengranularität eingebracht wird, der Gesamtjitter besser ist als der durch eine herkömmliche PLL mit mehreren Frequenzen erreichbar ist,

- verbesserte Taktgenauigkeit: gemäß der vorliegenden Erfindung kann bis zu der Referenzfrequenz, also der Frequenz des Mastertaktsignals, jede Zielfrequenz erzeugt werden, wobei die Genauigkeit der mittleren Frequenz lediglich durch die Bitbreite der verwendeten Interpolatoren begrenzt ist. Dem gegenüber waren herkömmliche, analoge PLLs auf die diskreten Frequenzen beschränkt, welche durch die PLL-Teilerelemente zugelassen waren,

- reduzierter Testaufwand: erfindungsgemäß wird die Menge an Analogschaltungen auf wenige, einfache und standardisierte Schaltungsblöcke reduziert, und die Schaltungskomplexität wird erfindungsgemäß auf digitale Teile übertragen, für die standardisierte und automatisierte Testverfahren herangezogen werden können,

- mehr synthetisierte Taktsignale pro Chip: nachdem traditionell eine praktische Beschränkung der Anzahl von PLLs gegeben war, welche pro Chip zugelassen war, ist diese Beschränkung erfindungsgemäß aufgehoben, da nun die unabhängigen Taktsignale von ein und derselben PLL abgeleitet werden können,

- reduzierte Siliziumfläche: nachdem die Schaltungskomplexität in den digitalen Teil der Schaltung verschoben ist, kann, anders als bei herkömmlichen Ansätzen, der Vorteil der hohen Dichte von Logikschaltungen, die mit Sub-Mikrometer-Prozessen erreichbar sind, in Anspruch genommen werden,

- reduzierte Pin-Anzahl (Anschlußstift-Anzahl): analoge PLLs erfordern eine zugeordnete Anzahl externer analoger Leistungsversorgungen, wohingegen erfindungsgemäß die Anzahl dieser Leistungsversorgungen reduziert werden kann, da lediglich eine PLL mit fester Frequenz für alle unabhängigen Taktsignale verwendet wird,

- reduzierte analoge Entwurfsanstrengungen: es sind lediglich wenige und relativ einfache analoge Blöcke erforderlich, die zu entwerfen sind, und die für jeden Chip in derselben Technologie wiederverwendet werden können,

- bessere Simulation/Emulation-Abdeckung: nachdem ein größerer Anteil des Schaltungsaufbaus in den digitalen Entwurfsbereich übergeht, können mittels einer digitalen Simulation und Emulation ein hoher Prozentsatz des Systems abgedeckt werden, und

- Entwurfsflexibilität der Schaltung: die Synthese eines bestimmten Taktsignals kann hardwaremäßig sehr flexibel entworfen werden, und später können genaue Takteigenschaften für ein optimales Verhalten, oder zur Umgehung von Fehlern, eingestellt werden.

Ein weiterer Vorteil der digitalen Taktsignalsynthese besteht darin, dass mit jeder Verbesserung oder mit jeder neuen digitalen Technologie durch die digitale Taktsignalsynthese ein verbessertes Verhalten und eine verbesserte Genauigkeit erhalten wird. Der Hauptparameter bei der digitalen Taktsignalsynthese besteht darin, die Phasengenauigkeit des Multi-Phasen-Taktsignals zu verbessern.

Nachdem alle Taktsignalparameter im digitalen Bereich manipuliert werden, wird hierdurch ermöglicht, ein Taktsignal auf sehr flexible Art und Weise an festgelegte Bedürfnisse anzupassen. Viele neue Anwendungen werden Vorteile aus dieser Eigenschaft ziehen, beispielsweise die präzise Verzögerung von Signalen durch Eintakten mit einem in der Phase verschiebbaren Takt.

Ferner ist es mit einem Mehrphasentaktsignal mit kurzem Tastzyklus auch möglich Taktsignale mit höheren Frequenzen als dem Mastertaktsignal zu erzeugen, da basierend aus den primären Flanken zusätzliche Taktflanken mit demselben Zyklus auf einfache Art und Weise berechnet werden können. Kürzere Multi-Phasen-Taktsignale können durch logisches Kombinieren von zwei Phasen abgeleitet werden. Die kürzest mögliche Hoch-Periode des Multi-Phasentaktsignals ist zweimal die Phasengenauigkeit.

Bevorzugte Ausführungsbeispiele der vorliegenden Erfindung werden nachfolgend unter Bezugnahme auf die beiliegenden Zeichnungen näher erläutert. Es zeigen:

Fig. 1      einen Multi-Phasen-Taktoszillator;

Fig. 2      den Verlauf der Mehrzahl von Multi-Phasen-Taktsignalen;

Fig. 3      eine Phasenüberlagerungseinheit gemäß einem Ausführungsbeispiel der vorliegenden Erfindung;

Fig. 4      den Verlauf der Signale in der Phasenüberlagerungseinheit gemäß Fig. 3;

Fig. 5A      den Verlauf der Verzögerung für die Aktivierungssignale für die Phasenüberlagerungseinheit gemäß Fig. 3;

Fig. 5B      ein Beispiel für eine Verzögerungseinheit, um den Verlauf in Fig. 5A zu erzeugen;

Fig. 6      einen primären Flankeninterpolator zum Bestimmen der führenden Flanken in dem Taktsignal;

Fig. 7      einen sekundären Flankenberechner, zum Bestimmen der nachfolgenden Flanken in dem Taktsignal;

Fig. 8      eine Phasenaktivierungseinheit zum Erzeugen der Aktivierungssignale;

Fig. 9      einen Verlauf eines Beibehaltungssignals;

Fig. 10      ein Beispiel für eine Taktgeneratoreinheit, die Einheiten aus Fig. 3, 6, 7 und 8 umfasst;

Fig. 11      den Verlauf der Signale in der Taktgeneratoreinheit aus Fig. 10;

Fig. 12      den Taktjitter für ein reales Taktsignal;

Fig. 13      eine Flankenerfassungseinheit, um Flanken in einem Synchronisationssignal zu erfassen;

Fig. 14      einen Flankenpositionsdecoder, um Positionen der Flanken in dem Synchronisationssignal zu erfassen;

Fig. 15      eine Taktparameterberechnungseinheit;

Fig. 16      ein IIR-Filter;

Fig. 17    einen primären Flankeninterpolator gemäß einem zweiten Ausführungsbeispiel;

Fig. 18    eine synchrone Takterzeugungseinheit, zur Erzeugung eines synchronen Taktsignals, welche die Einheiten aus Fig. 3, 7, 8 13, 14, 15 und 17 umfasst;

Fig. 19    ein Blockdiagramm eines System zur beliebigen Taktsynthese (Arbitrary Clock Synthesis) gemäß einem Ausführungsbeispiel der vorliegenden Erfindung;

Fig. 20    einen Spreadspektrum-Interpolator;

Fig. 21    das Sweep-Verhalten des Spreadspektrum-Taktes;

Fig. 22    ein Beispiel für einen modularen Aufbau des erfindungsgemäßen Taktgenerators.

Nachfolgend werden anhand der beiliegenden Zeichnungen bevorzugte Ausführungsbeispiele näher beschrieben, wobei bei der Beschreibung der einzelnen Zeichnungen ähnliche oder gleichwirkende Elemente mit gleichen Bezugszeichen versehen sind.

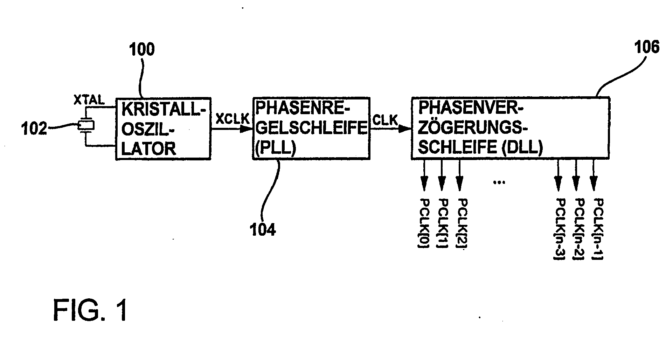

Fig. 1 zeigt ein Beispiel für einen Multi-Phasen-Taktoszillator, welcher einen Kristalloszillator 100 umfasst, der mit einem Schwingkristall 102 gekoppelt ist, um ein Oszillator-Taktsignal XCLK auszugeben. Das Oszillator-taktsignal XCLK wird durch eine Phasenregelschleife (PLL) 104 empfangen, welche basierend auf dem empfangenen Oszillatortaktsignal ein Mastertaktsignal CLK erzeugt, welches der Phasenverzögerungsschleife (DLL = Delay Locked Loop) bereitgestellt wird. Die DLL 106 erzeugt auf der Grundlage des angelegten Mastertaktsignals CLK eine Mehrzahl von Taktsignalen PCLK[0] ..... PCLK[n-1]. Die erzeugten Taktsignale haben alle die gleiche Frequenz, weisen jedoch gegenüber dem Mastertaktsignal CLK jeweils unterschiedliche Phasenbeziehungen auf, und haben somit auch zueinander unterschiedliche Phasenbeziehungen.

Die digitale Taktsignalsynthese (DCS) verwendet das Mastertaktsignal CLK, aus dem mittels der DLL 106 die Taktsignale PCLK[n-1:0] mit $2^{n-1}$ Phasen gewonnen wird. Neben dem anhand der Fig. 1 beschriebenen Ansatz kann ein solcher Multiphasen-Takt auch mit anderen Techniken erzeugt werden, einschließlich des herkömmlichen, und dem in Fig. 1 gezeigten PLL + DLL Ansatz.

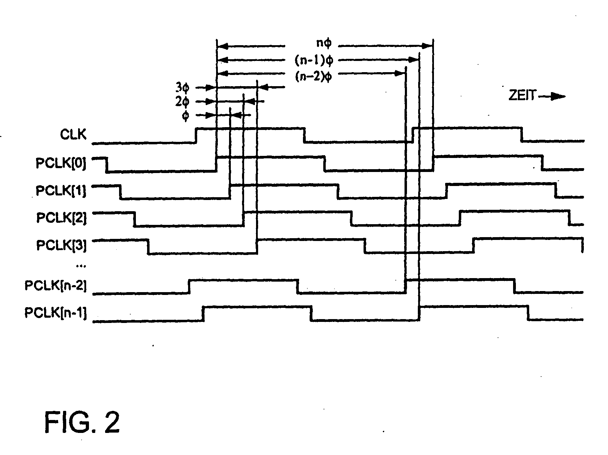

In Fig. 2 ist der Verlauf der einzelnen Taktsignale PCLK sowie des Mastertaktsignals CLK über der Zeit aufgetragen. Ferner sind die zwischen den einzelnen Taktsignalen PCLK[0] bis PCLK[n-1] existierenden Phasenverschiebungen dargestellt. Wie aus Fig. 2 zu erkennen ist, ist bei dem dort dargestellten Ausführungsbeispiel die Phasenverschiebung zwischen aufeinanderfolgenden Taktsignalen immer gleich φ, so dass beispielsweise zwischen einer ansteigenden Taktflanke des ersten Taktsignals PCLK[0] und der ersten ansteigenden Flanke des darauffolgenden Taktsignals PCLK[1] eine Phasendifferenz von φ existiert. Die Phasendifferenz zwischen zwei aufeinanderfolgenden ansteigenden Flanken eines Taktsignals beträgt immer n • φ.

Die mögliche Genauigkeit aller synthetisierten Taktsignale hängt hauptsächlich von der Phasenauflösung φ dieser Multi-Phasen-Taktsignale PCLK ab. Die maximal mögliche "Phasenauflösung" ist eine Funktion der Gatterlaufzeiten, wobei für höhere Frequenzen weniger Verzögerungsabgriffstellen verwendet werden können, und umgekehrt. Für φ gilt die folgende Berechnungsvorschrift:

$$\phi = \frac{T_{CLK}}{n} = \frac{1}{n \cdot f_{CLK}}$$

mit

φ =        Phasenauflösung,
$T_{CLK}$ =        Periode des Mastertaktsignals,
$f_{CLK}$ =        Frequenz des Mastertaktsignals, und
n =        0, 1, 2, ...

Es ist wünschenswert, das Mastertaktsignal CLK bei einer festen Frequenz oder zumindest in einem schmalen Bereich zu halten, um so die Möglichkeit zu geben, die verwendete PLL-Schaltung 104 sowie die verwendete DLL-Schaltung 106 für eine maximale Stabilität zu optimieren. Nachdem lediglich ein Taktsignal mit einer festen Frequenz verwendet wird, um alle Taktsignale für ein System zu erzeugen, können alle Bemühungen darauf gerichtet werden, diesen einen Takt so stabil wie möglich zu machen, beispielsweise durch geeignete Filter, getrennte Leistungsanschlüsse, optimale Anordnung auf einem Chip, etc. Alle hieraus erzeugten Taktsignale zeigen dann auch die Stabilität dieser zentralen Quelle.

In der nachfolgenden Tabelle sind Beispiele für Mastertaktsignale angegeben, sowie Beispiele für die Anzahl der verwendeten Phasen n, abhängig von der durch die HalbleiterTechnologie vorgegebenen minimalen Strukturgröße, in der die entsprechenden DLL- und PLL-Schaltungen gefertigt werden.

| Technologie | max. Frequenz $f_{CLK}$ | Anzahl der Phasen n | Phasenauflösung $\phi$ |
|---|---|---|---|
| 0,25 $\mu$m | 166 MHz | 32 | 188 ps |
| 0,18 $\mu$m | 250 MHz | 32 | 125 ps |
| | 500 MHz | 16 | 125 ps |

Nachfolgend wird ein erstes bevorzugten Ausführungsbeispiel der vorliegenden Erfindung näher erläutert, mittels dem unabhängige Taktsignale basierend auf den erzeugten Taktsignalen, wie sie oben beschrieben wurden, synthetisiert werden.

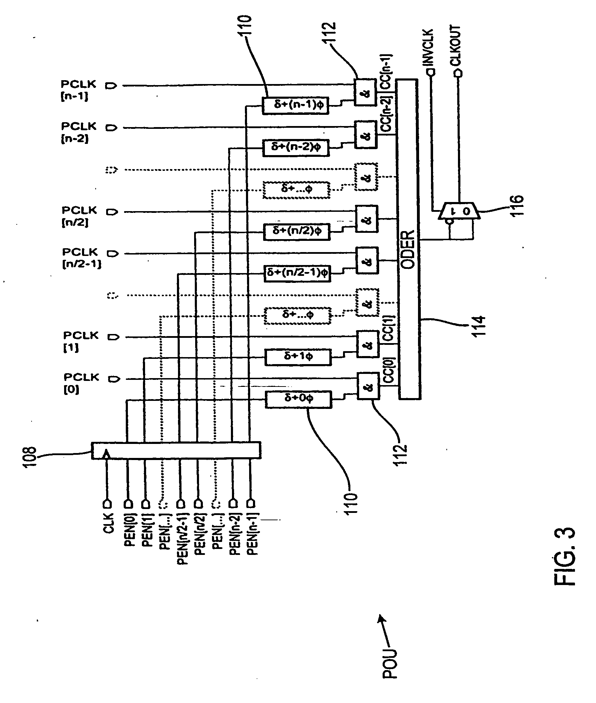

In Fig. 3 ist ein Ausführungsbeispiel einer erfindungsgemäßen Phasenüberlagerungseinheit (POU = Phase Overlay Unit) gezeigt. Die Phasenüberlagerungseinheit empfängt die durch die DLL-Schaltung 106 erzeugten Taktsignale PCLK[0] bis PCLK[n-1] an ihren Eingängen. Ferner empfängt die Phasenüberlagerungseinheit das Mastertaktsignals CLK sowie ein Steuerungssignal, hier in der Form einer Mehrzahl von Aktivierungssignalen PEN[0] bis PEN[n-1] (PEN = Phase Enable). Die Aktivierungssignale PEN[] werden einem Eingangspuffer 108 bereitgestellt, durch den dieselben unter Verwendung des Mastertaktsignals CLK durchgetaktet werden. Die Phasenüberlagerungseinheit umfasst ferner eine Mehrzahl von Verzögerungselementen 110, wobei die Anzahl der Verzögerungselemente 110 der Anzahl der anliegenden Aktivierungssignale PEN[] entspricht. Ein Aktivierungssignal wird jeweils einem Verzögerungselement 110 bereitgestellt, und dort wird das Verzögerungssignal einer eingestellten Verzögerung $\Delta$, zu der zusätzlich eine Verzögerung basierend auf der Phasenverschiebung hinzugefügt wird, verzögert. Die jeweils hinzugefügte Phasenverzögerung ergibt sich aus den in Fig. 3 gezeigten Verzögerungselementen 110. Ferner ist eine Mehrzahl von UND-Gattern 112 vorgesehen, wobei jedes der UND-Gatter 112 ein Ausgangssignal eines Verzögerungselements 110, also ein verzögertes Aktivierungssignal PEN[] sowie ein Taktsignal PCLK[] empfängt, und einer logischen UND-Verknüpfung unterwirft. Am Ausgang der UND-Gatter 112 liegen die Ausgangssignale CC[0] bis CC[n-1] an. Diese Ausgangssignale werden einem ODER-Gatter 114 zugeführt, dessen Ausgangssignal einem Multiplexer 116 einmal in nichtinvertierter Form und zum anderen in invertierter Form zugeführt wird. Der Multiplexer 116 wird angesteuert, und gibt im herkömmlichen Ansteuermodus das nicht-invertierte Taktsignal CLKOUT aus. Wird der Multiplexer 116 mittels des Steuersignals INVCLK angesteuert, so bedeutet dies, dass ein invertiertes Taktsignal erwünscht ist, so dass in diesem Fall der invertierte Ausgang des ODER-Gatters 114 als Taktausgangssignal CLKOUT ausgegeben wird.

Die erfindungsgemäße digitale Taktsignalsynthese überlagert somit die mehrfachen Phasen des Mastertaktsignals miteinander, um den zu erzeugenden Takt zu bilden bzw. zu formen. Dies wird durch die oben beschriebene einfache UND-ODER-Schaltung erreicht. Für jede Taktsignalphase PCLK[] wird ein individuelles Aktivierungssignal PEN[] bereitgestellt. Alle elementaren Pulse mit hohem logischen Pegel des Multi-Phasen-Taktsignals, die aktiviert sind, werden mittels des ODER-Gatters verknüpft, um längere Pulse mit hohem logischen Pegel zu erzeugen. Grundsätzlich bestimmt das erste aktive Aktivierungssignal die positive Flanke des Ausgangssignals CLKOUT, und das erste nichtaktive Aktivierungssignal bestimmt dessen negative Flanke. Nachdem die Perioden mit hohem logischen Pegel der Taktsignalphasen zeitlich verschoben sind, müssen deren Aktivierungssignale ausgerichtet sein, um ausreichende Einstell- und Halte-Zeiten (Set-Time und Hold-Time) zu garantieren. Dies wird dadurch erreicht, dass zusätzlich auch die Aktivierungssignale verzögert werden, wobei hier verschiedene Möglichkeiten für die Implementierung dieser Verzögerung existieren, wobei später noch eine bevorzugte Implementierung näher erläutert wird.

Der kürzeste Puls mit hohem logischen Pegel, der mit der in Fig. 3 gezeigten Schaltung erzeugt werden kann, wird eine Dauer des elementaren Taktpulses haben. Pulse mit niedrigem logischen Pegel können schmaler sein und sind lediglich durch die Phasenauflösung beschränkt. Sofern schmalere Pulse mit hohem logischen Pegel erwünscht sind, kann die oben beschriebene Taktsignalinvertierung ausgewählt werden.

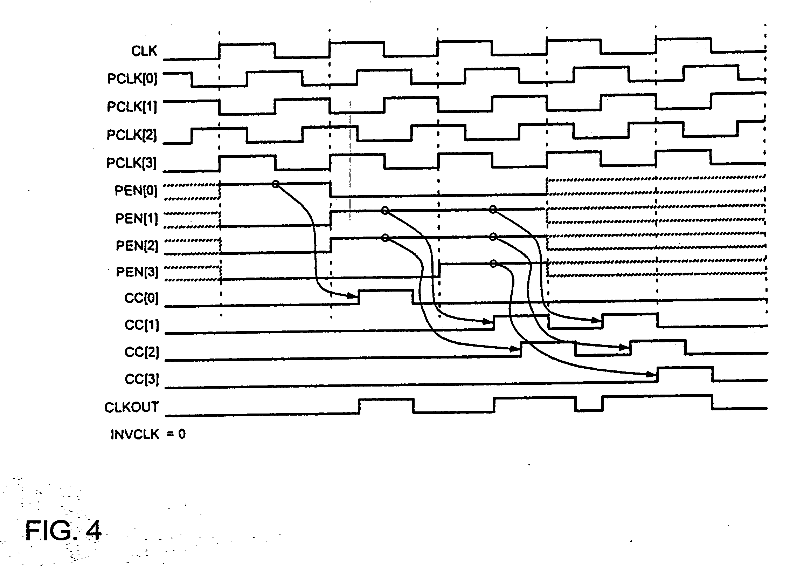

In Fig. 4 ist beispielhaft eine Taktüberlagerung für vier Taktsignale mit unterschiedlichen Phasen PCLK[0] bis PCLK[3] gezeigt, wobei durch die Ansteuerung der entsprechenden Aktivierungssignale PEN[0] bis PEN[3] die Synthese eines nicht-periodischen Taktsignals dargestellt ist. Das durch die Aktivierungssignale PEN[] festgelegte Aktivierungsmuster steuert die Länge der individuellen Perioden mit hohem logischen Pegel und der Perioden mit niedrigem logischen Pegel und formt die Pulszüge, die, wie erwähnt, in dem dargestellten Fall nicht periodisch sind. In Fig. 4 sind ferner die Ausgangssignale CC[0] bis CC[3] der UND-Gatter 112 wiedergegeben. Ferner ist der Ausgang des ODER-Gatters 114 CLKOUT dargestellt, und INVCLK ist zu 0 gewählt. Aus dem Verlauf des Ausgangstaktsignals CLKOUT ist zu erkennen, dass basierend auf dem Muster der Aktivierungssignale, wie sie bereitgestellt werden, im Ausgangstaktsignal die Periode mit hohem logischen Pegel und die Perioden mit niedrigem logischen Pegel jeweils unterschiedliche Länge aufweisen, und das Ausgangssignal auch nicht periodisch ist.

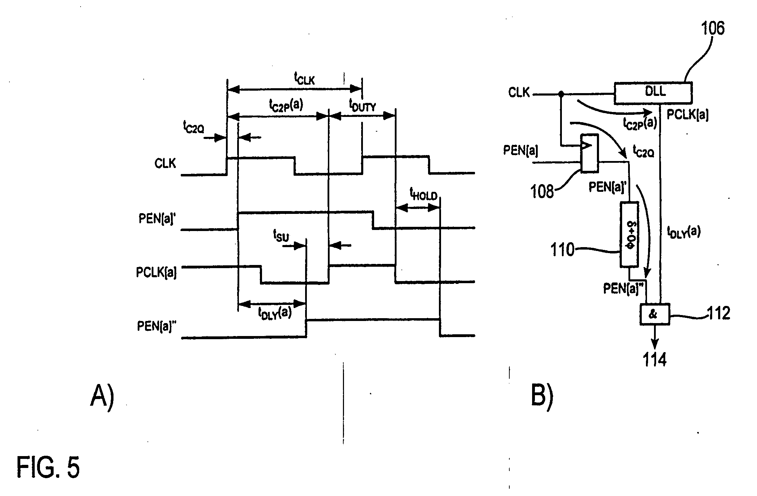

Nachfolgend wird anhand der Fig. 5 ein Beispiel für die Verzögerung der Aktivierungssignale näher erläutert, wobei in Fig. 5A die Signalverläufe der Signale, wie sie in Fig. 5B verwendet werden, dargestellt sind. Fig. 5 ist ein Beispiel, das von den ohnehin vorhandenen Verzögerungselementen in der Phasenüberlagerungseinheit und in der DLL 106 Gebrauch macht, so dass in Fig. 5B die entsprechenden Elemente mit den entsprechenden Bezugszeichen versehen sind. Tatsächlich ist Fig. 5B eine vergrößerte Darstellung eines Ausschnitts aus Fig. 3, wie ohne weiteres zu erkennen ist. In Fig. 5B sind die in den einzelnen Elementen auftretenden Verzögerungszeiten dargestellt.

Herkömmlicherweise wird die DLL-Schaltung 106, die das Multi-Phasen-Taktsignal erzeugt, unter Verwendung von verzögerungsgesteuerten Puffern bereits realisiert. Das Signal, welches die Verzögerung der DLL-Pufferkettenelemente steuert, kann erneut verwendet werden, um alle Verzögerungen für die Aktivierungssignale zu replizieren. Die individuellen Verzögerungen können gemäß der nachfolgenden Berechnungsvorschrift dimensioniert werden:

$$t_{DEL}(a) = \delta + a \cdot \phi = t_{C2P}(a) - t_{C2Q} - t_{SU}$$

$$t_{C2P}(a) = t_{C2P}(0) + a \cdot \phi$$

$$\delta = t_{C2P}(0) - t_{C2Q} - t_{SU}$$

$$t_{HOLD} = t_{CLK} - t_{DUTY} - t_{SU} = t_{CLK} - t_{DUTY} - t_{C2P}(0) + t_{C2Q} + \delta$$

mit:

| | |
|---|---|
| $t_{DEL}(a)$ = | Verzögerung des Aktivierungssignals PEN[a], |
| $\Delta$ = | Verzögerung, |
| $a$ = | 0, 1, 2, .... n-1, |
| $\phi$ = | Phase, |
| $t_{C2P}(a)$ = | Verzögerung der DLL 106, |
| $t_{C2Q}$ = | Verzögerung aufgrund des Eingangspuffers 108 |
| $t_{SU}$ = | SetUp-Zeit für das UND-Gatter 112, |
| $t_{HOLD}$ = | Hold-Zeit für das UND-Gatter 112, |
| $t_{DUTY}$ = | High-Periode des Taktsignals, und |
| $t_{CLK}$ = | Periode des Mastertaktsignals |

Der Vorteil dieses analogen Verzögerungsmechanismus besteht darin, dass die Schaltung hinsichtlich Änderungen des Tastzyklus des Mastertaktsignals weitestgehend immun ist. Es ist nicht erforderlich, dass die Verzögerungsreproduktion sehr genau ist, nachdem die Einstell- und Haltezeit ($t_{SU}$, $t_{HOLD}$) für das UND-Gatter 112 klein sind.

Alternativ zu dem oben beschriebenen Ansatz kann ein Zwischenspeicher-Mechanismus (Latch-Mechanismus) vorgesehen sein, der einige der Taktsignalphasen verwendet. Diese rein digitale Vorgehensweise hat jedoch den Nachteil, dass die Multi-Phasen-Taktsignalleitungen mit einer höheren Lastkapazität belastet sind.

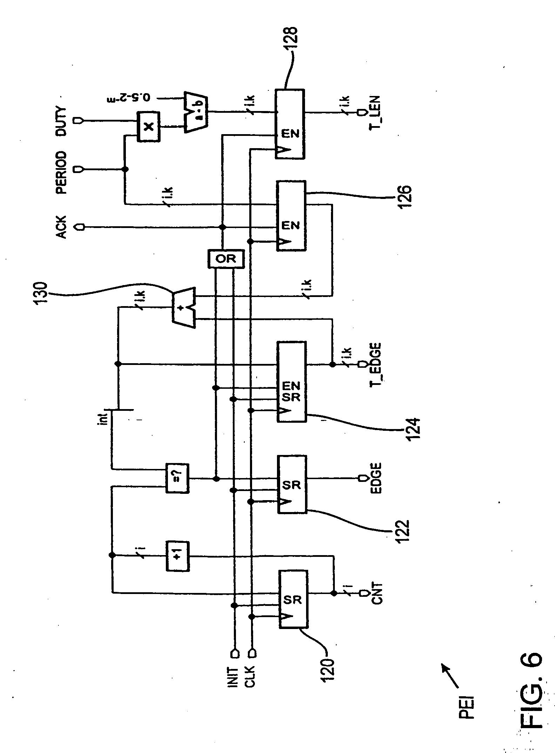

Nachfolgend wird ein zweites Ausführungsbeispiel der vorliegenden Erfindung näher erläutert, um ein periodisches Taktsignal, welches hinsichtlich Frequenz und Tastzyklus fast beliebig programmierbar ist, zu erstellen. Bei dieser Taktsignalinterpolation wird eine geeignete Sequenz von Aktivierungssignalen bereitgestellt, um das periodische Signal mit nahezu jeglicher Frequenz und jeglichem Tastzyklus bis hoch zur Mastertaktsignalgeschwindigkeit zu synthetisieren. Um das geeignete Aktivierungsmuster zu erzeugen, muss zunächst die Position der führenden Flanken des erwünschten Takts interpoliert werden, wozu der in Fig. 6 näher gezeigte primäre Flankeninterpolator PEI (PEI = Primary Edge Interpolator) herangezogen wird.

Der primäre Flankeninterpolator empfängt das Signal PERIOD, welches eine Periode des erwünschten Taktsignals anzeigt. Ebenso empfängt der Interpolator das Signal DUTY, welches den Tastzyklus des erwünschten Taktsignals angibt. Der Interpolator umfasst eine Mehrzahl von Latch-Speichern 120 bis 128, die mit dem Mastertaktsignal CLK getaktet sind und durch ein D-Flipflop gebildet sind.

Die nachfolgende Tabelle beschreibt die in der Beschreibung der nachfolgenden Figuren verwendeten Symbole.

| Symbol | Beschreibung |
|---|---|
| PERIOD | erwünschte Taktperiode in Einheiten der Referenz-taktzyklen für das erzeugte Signal CLKOUT |
| DUTY | erwünschtes Tastverhältnis für das erzeugte Takt-signal CLKOUT |
| INIT | initialisiert den Phaseninterpolator; der Interpolator wird angehalten und auf 0 gesetzt; unmittelbar nach dem Ausgeben des Signals INIT wird eine führende Flanke ausgegeben |
| EDGE | Flag, die anzeigt, dass in dem derzeitigen Mastertaktsignalzyklus eine primäre Flanke erzeugt werden sollte |
| T_EDGE | Zeitpunkt, um die primäre Flanke zu erzeugen |
| T_LEN | Länge der Taktpulse mit hohem logischen Pegel |
| LEAD | Flag, die anzeigt, dass in dem derzeitigen Mastertaktsignalzyklus eine führende Kante (Flanke) erzeugt werden sollte |
| TRAIL | Flag, die anzeigt, dass in dem derzeitigen Mastertaktsignalzyklus eine nachfolgende Flanke erzeugt werden sollte |
| P_LEAD | Position des Pulses, der die führende Flanke innerhalb des derzeitigen Mastertaktzyklus bildet |
| P_TRAIL | Position des Pulses, der die nachfolgende Flanke innerhalb des derzeitigen Mastertaktzyklus bildet |
| i.k | Auflösung der Zeitdauerparameter in Mehrfachen der Mastertaktsignalzyklen [Ganzzahl-Bits. Bruchzahl-Bits] |
| i | Auflösung für den Mastertaktsignalzähler [Bits] |
| n | Anzahl der Taktphasen, Potenzen von 2 |
| m | Auflösung des Phasenselektors [Bits], $m = \log_2(n)$ |

Nachfolgend wird die Funktionalität des primären Flankeninterpolators aus Fig. 6 näher erläutert. CMC bezeichnet einen freilaufenden Zähler, der bei jedem Mastertaktsignalzyklus um 1 inkrementiert wird. Dieser schafft einen kontinuierlichen Zeitstempel für jeden Mastertaktsignalzyklus. T_EDGE ist der Zeitpunkt gemäß dem Zeitstempel, zu dem die nächsten führende Flanke auftreten muss. Dieser Zeitpunkt wird interpoliert, indem die Taktperiode (PERIOD) zu der vorhergehenden führenden Flanke hinzuaddiert wird, wie dies durch den Addierer 130 in Fig. 6 gezeigt ist. Immer wenn der nächste Zählwert und der nächste Zeitstempel der Flanke ein gleiches Ganzzahl-Bit haben, muss der nächste Zyklus eine führende Flanke enthalten. Ein aktives EDGE-Signal zusammen mit dem Flankenerzeugungszeitpunkt T_EDGE zeigt dieses Ereignis, dass der nächste Zyklus eine führende Flanke haben muss, am Ausgang an. Nur eine führende Flanke pro Mastertaktsignalzyklus kann bei der in Fig. 6 gezeigten Schaltung auftreten. Das Signal PERIOD wird im Latch-Speicher 126 bei jeder führenden Flanke zwischengespeichert, um Nebeneffekte zu vermeiden, wenn dieses Signal während des Zyklus des gerade erzeugten Taktsignals verändert wird. Parallel zu der Taktsignalperiode wird die Dauer des erwünschten Taktsignalpulses T_LEN, also die Zeit zwischen der führenden Flanke und der nachfolgenden Flanke berechnet, und über den Latch-Speicher 128 am Ausgang bereitgestellt. Dies ist eine Funktion des Tastzyklus, der zwischen 0 und 1 ist. Es ist ebenfalls darauf zu achten dass auch dann wenn der Multi-Phasen-Takt deaktiviert wird, die vorhergehende Aktivierungstaktsignalphase für eine vorbestimmte Zeit immer noch beibehalten wird, wobei gilt:

$$t_{sustain} = t_{master,high} - \phi$$

mit:

$t_{sustain}$ = Beibehaltungszeit
$t_{master,high}$ = Zeitdauer bei der der Mastertakt auf einem hohen Pegel ist,
$\phi$ = Phase

Daher muss die Pulsdauer des erzeugten Taktes, die basierend auf dem Tastzyklus berechnet wird, um die Beibehaltungszeit reduziert werden.

Erfindungsgemäß können die Periode des erwünschten Taktsignals und/oder der Tastzyklus des erwünschten Taktsignals während des Betriebs (on the fly) verändert werden, wobei diese Änderungen mit dem nächsten synthetisierten Taktsignalzyklus wirksam werden. Die Annahme des Signals PERIOD und des Signals DUTY werden mittels eines Bestätigungssignals ACK angezeigt. Mittels des Initialisierungssignals INT kann der erzeugte Takt sofort auf 0 gezwungen werden. Nach der Ausgabe des Signals INIT an die Schaltung in Fig. 6 wird eine führende Flanke nach einer Periode gemäß dem Signal PERIOD ausgegeben.

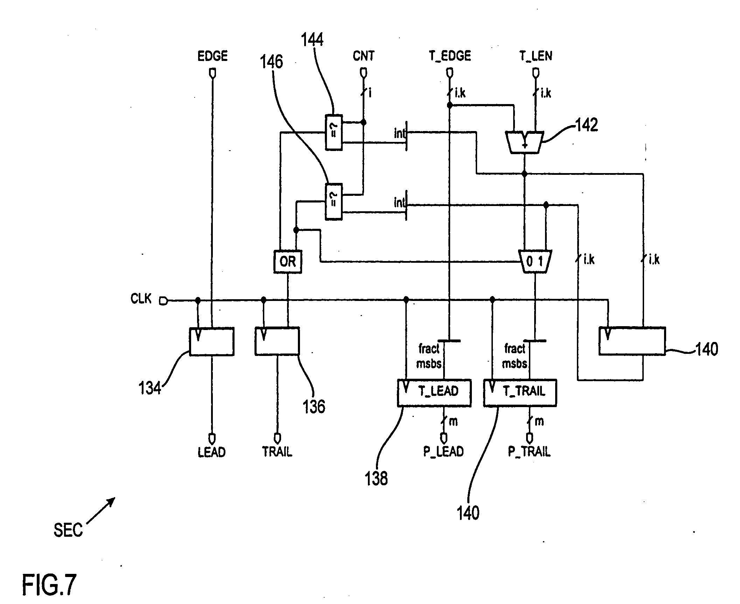

Nachdem die primäre oder vorauseilende Flanke des erwünschten Taktsignals berechnet wurde, muss nun die nachfolgende/sekundäre Flanke ausgehend von der führenden/primären Flanke berechnet werden, was bei dem dargestellten Ausführungsbeispiel mittels des sekundären Flankenberechners SEC (SEC = secondary edge calculator) erfolgt, dessen bevorzugter Aufbau in Fig. 7 im Detail dargestellt ist. Wie zu erkennen ist, empfängt der SEC eine Mehrzahl von Eingangssignalen, welche in der obigen Tabelle bereits erläutert wurden. Zusätzlich umfasst die Schaltung eine Mehrzahl von Latch-Speichern 134 bis 140. Die Schaltung gemäß Fig. 7 arbeitet derart, dass die erwünschte Pulslänge zu dem Zeitpunkt der Ausgabe der Flanke durch den Interpolator in Fig. 6 hinzuaddiert wird, wie dies durch den Addierer 142 in Fig. 7 dargestellt ist. Falls noch eine sekundäre Flanke darauf wartet, für den derzeitigen Masterzyklus ausgegeben zu werden, wird die neue sekundäre Flankenzeit um einen Masterzyklus verzögert. Diese wird in diesem Masterzyklus nicht benötigt, da pro Zyklus lediglich eine sekundäre Flanke zugelassen ist.

Das die Erzeugung der führenden Flanke anzeigende Signal LEAD und die Position der führenden Flanken P_LEAD innerhalb des Mastertakt-Zyklusses werden im Zwischenspeicher 134 bzw. 138 zwischengespeichert. Das die Erzeugung der nachfolgenden Flanke anzeigende Signal TRAIL wird gesetzt, sobald der Zeitstempel des nächsten Mastertaktzyklus gleich dem ganzzahligen Anteil der berechneten Position der nachfolgenden Kante (Flanke) ist, wie dies durch die Vergleichsoperationen 144 und 146 angedeutet ist. Dieser Vergleich muss auch für die verzögerte Version der Startzeit durchgeführt werden (siehe Vergleicherelement 146, das die im Speicher 140 zwischengespeicherte und damit verzögerte Version empfängt. Die Positionen der Flanken innerhalb eines Zyklus werden durch die nicht-ganzzahligen Anteile der berechneten Kantenpositionen beschrieben (sub cycle position).

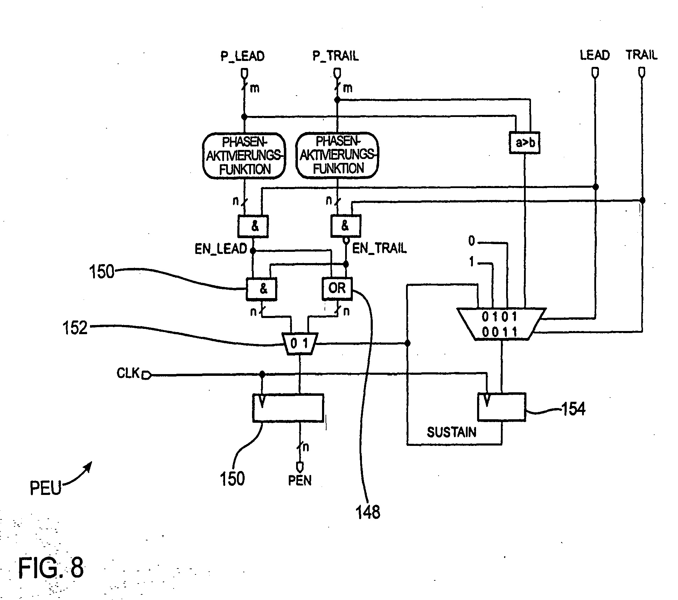

Nachdem auf die oben beschriebene Art und Weise nun die Kantenpositionen und die Erzeugungs-Flags bereitgestellt wurden, kann mittels der Phasenaktivierungseinheit PEU (PEU = phase enable unit), die in Fig. 8 gezeigt ist, das für die Erzeugung des erwünschten Taktsignals erforderliche Aktivierungssignalmuster abgeleitet werden. Die in Fig. 8 gezeigten Phasenaktivierungsfunktion erzeugt das Aktivierungsmuster lediglich für eine einzelne Flanke, und das Aktivierungsmuster für einen Gesamtpuls ergibt sich durch die Überlagerung von zwei Phasenaktivierungsmustern, wie dies in Fig. 8 gezeigt ist.

In der nachfolgenden Tabelle ist die Phasenaktivierungsfunktion nochmals verdeutlicht.

| P_LEAD P TRAIL | Phase | EN[0:n-1] | EN[0:n-1] |
|---|---|---|---|
| 0 | 0 | $(1111..111)_2$ | $(0000..000)_2$ |
| 1 | $\phi$ | $(0111..111)_2$ | $(1000..000)_2$ |
| 2 | $2\phi$ | $(0011..111)_2$ | $(1100..000)_2$ |
| ... | ... | ... | ... |
| n-2 | $(n-2)\phi$ | $(0000..011)_2$ | $(1111..100)_2$ |
| n-1 | $(n-1)\phi$ | $(0000..001)_2$ | $(1111..110)_2$ |

Die Flankenerzeugungsflags aktivieren die entsprechenden Flankenaktivierungsmuster, wobei das Muster betreffend die nachfolgende Flanke ferner invertiert wird. Abhängig von dem Signal SUSTAIN werden die zwei Muster entweder mittels einer ODER-Funktion 148 oder einer UND-Funktion 150 kombiniert. Die Auswahl erfolgt mittels eines Multiplexers 152, der durch das Signal SUSTAIN, welches im Zwischenspeicher 154 bereitsteht, angesteuert wird. Das Aktivierungssignal PEN wird im Zwischenspeicher 156 zwischengespeichert und unter Steuerung des Mastertaktsignals CLK ausgegeben.

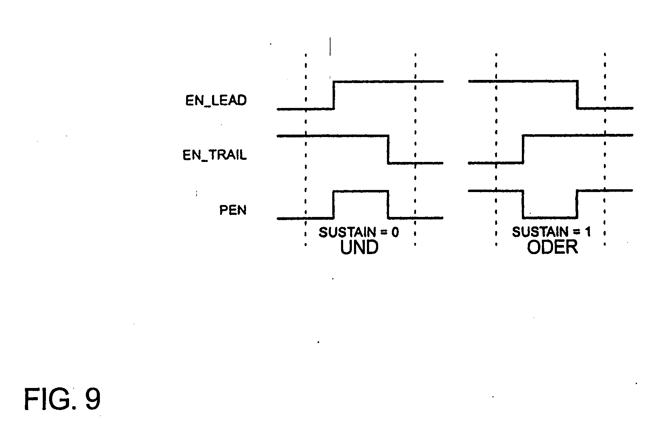

Das Signal SUSTAIN ist vorgesehen, um zu speichern, ob die letzte ausgegebene Flanke eine führende Flanke oder eine nachfolgende Flanke war. Das Signal SUSTAIN wird durch ein einzelnes LEAD-Signal gesetzt, und durch ein einzelnes TRAIL-Signal zurückgesetzt. Wenn weder das Signal LEAD noch das Signal TRAIL ausgegeben werden, behält das Signal SUSTAIN seinen Status bei, wie dies aus dem Signalverlauf in Fig. 9 zu entnehmen ist. Wenn beide Kanten in einem Mastertaktzyklus auftreten, bestimmen deren Position den Wert des Signals SUSTAIN. Durch das Signal SUSTAIN wird somit sichergestellt, dass in Zyklen, in denen keine Flankenaktivität existiert, die korrekte Taktsignalpolarität beibehalten wird.

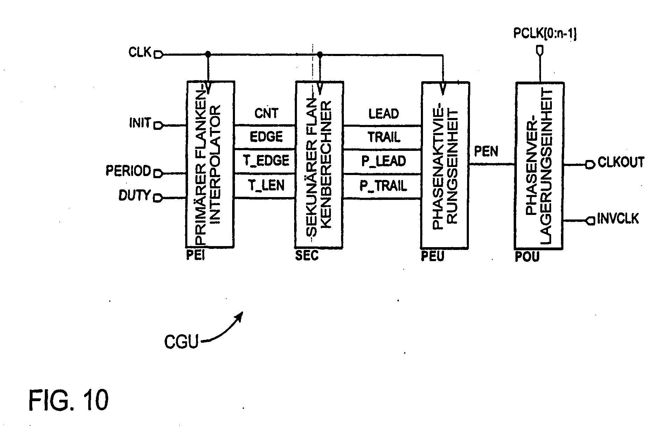

In Fig. 10 ist eine Takterzeugungseinheit CGU (CGU = Clock Generation Unit) gezeigt, in der die im vorhergehenden beschriebenen einzelnen Module kombiniert sind, um einen frei programmierbaren, freilaufenden Takt zu erzeugen. Der primäre Flankeninterpolator berechnet aufeinanderfolgende Positionen der führenden Taktflanke und der Pulslängen der Taktsignale mit hohem logischen Pegel. Der sekundäre Flankenberechner leitet die Position der nachfolgenden Flanke ab. Die Phasenaktivierungseinheit kombiniert ein Phasenaktivierungsmuster aus diesen Informationen, und in der Phasenüberlagerungseinheit werden die aktivierten Multi-Zyklus-Taktsignale mit hohen logischen Pulsen logisch mittels einer ODER-Verknüpfung kombiniert, um so das Ausgangssignal CLKOUT, welches das erwünschte Taktsignal ist, zu erzeugen.

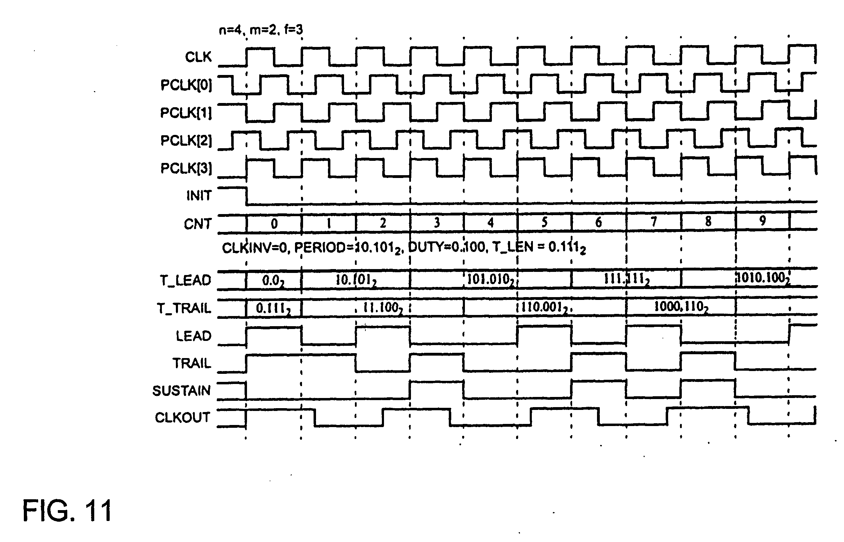

Fig. 11 zeigt den Signalverlauf für eine Taktsignalüberlagerung unter Verwendung von vier Phasen PCLK[0] bis PCLK[3], wobei in Fig. 11 die binären Werte für die Signale PERIOD, DUTY und T_LEN angegeben sind. Fig. 11 zeigt ein Beispiel für die Taktsignalsynthese unter Verwendung eines Multi-Phasen-Mastertaktsignals mit lediglich vier Phasen, wobei dies aus Gründen der Übersichtlichkeit gewählt wurde. Es wird darauf hingewiesen, dass die Bruchteilgenauigkeit des Interpolators höher ist, als dies erforderlich wäre, zwischen den vier Phasen zu unterscheiden, was jedoch sinnvoll ist, da dies die Auflösung für die mittlere erzeugte Frequenz erhöht. Phasenpositionen, die das Phasengitter nicht treffen, werden auf die nächstniedrige Phase abgerundet.

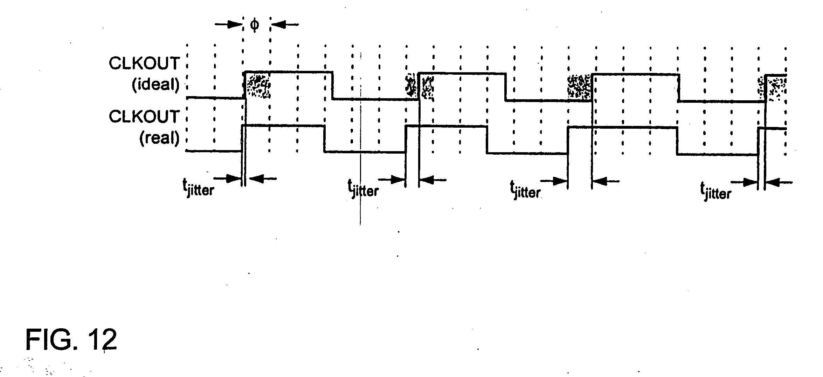

Aufgrund dieses Rundungsvorgangs, der aus den oben genannten Gründen durchgeführt wird, wird ein systematischer Jitter eingebracht, wie er in Fig. 12 aus dem Vergleich eines idealen Ausgangssignals mit einem realen Ausgangssignal ergibt. Der Betrag von Spitzenwert zu Spitzenwert dieses Jitters ist gleich der Phasenauflösung. Dieser Jitter wird zu dem intrinsischen Jitter der Multiphasentaktsignale hinzugeführt, so dass gilt:

$$t_{(jitter,CLKOUT)} = t_{(jitter,PCLK)} + \phi$$

Die Breite des Zählers (i) für den Mastertaktzyklus wird durch die maximale Taktzyklusperiode bestimmt, die synthetisiert werden kann, wobei sich die maximale Taktzyklusperiode wie folgt berechnet:

$$t_{CLKOUT,MAX} = \frac{1}{f_{CLKOUT,MIN}} = \frac{2^i}{f_{CLK}}$$

Die erforderliche Zählergenauigkeit i ergibt sich dann wie folgt:

$$i = \log_2 \left( \frac{f_{CLK}}{f_{CLKOUT,MIN}} \right)$$

mit

$f_{CLK} = $ Frequenz des Mastertaktsignals, und
$f_{CLKMIN} = $ minimale Frequenz, die zu synthetisieren ist

Aufgrund der beschränkten Interpolatorauflösung können nur diskrete Taktperioden mit einer Granularität $\Delta T_{CLKOUT}$ erzeugt werden. $\Delta t$ berechnet sich wie folgt:

$$\Delta t_{CLKOUT} = \frac{1}{f_{CLK}} \cdot 2^{-k}$$

Frequenzen können mit diskreten Schritten von $\Delta f_{CLKOUT}$ erzeugt werden, wobei die Schritte für höhere, synthetisierte Frequenzen zwischen möglichen Werten größer werden, so dass gilt:

$$\Delta f_{CLKOUT} = f_{CLKOUT}{}^2 \cdot \Delta t_{CLKOUT}$$

Um die erforderliche Bruchteilauflösung des Interpolators festzustellen, muss die maximale Frequenz, die zu synthetisieren ist, berücksichtigt werden, so dass für die erforderliche Bruchteilauflösung k des Interpolators gilt:

$$k \geq \log_2 \left( \frac{1}{f_{CLK} \cdot \Delta t_{CLKOUT,MIN}} \right) = \log_2 \left( \frac{f_{CLKOUT,MAX}{}^2}{f_{CLK} \cdot \Delta f_{CLKOUT}} \right)$$

Wenn die maximale Frequenz gleich der Master-TaktsignalFrequenz ist, kann die Gleichung für k wie folgt vereinfacht werden:

$$k \geq \log_2 \left( \frac{f_{CLK}}{\Delta f_{CLKOUT}} \right) \quad \text{for} \quad f_{CLKOUT,MAX} = f_{CLK}$$

Beispielhaft sei ein Mastertakt mit eine Frequenz von 250 MHz mit 32 Phasen angenommen. Basierend auf diesem Mastertakt soll ein Takt mit einem Frequenzbereich von 1,0MHz bis zur Mastertaktfrequenz erzeugt werden, mit einer Genauigkeit von 20ppm. Für dieses Beispiel gilt:

$$i = \log_2 \left( \frac{f_{CLK}}{f_{CLKOUT,MIN}} \right) = \left( \frac{250MHz}{1MHz} \right) \approx 7{,}97 \rightarrow i = 8$$

$$k \geq \log_2 \left( \frac{f_{CLK}}{\Delta f_{CLKOUT}} \right) = \left( \frac{1}{0{,}00002} \right) \approx 15{,}61 \rightarrow k = 16$$

Für dieses Beispiel muss der Interpolator somit 8 ganzzahlige Bits (integer bits) und 16 Bruchzahlbits (fractional bits) aufweisen, also 24 Bit insgesamt.

Nachfolgend wird ein weiteres bevorzugtes Ausführungsbeispiel der vorliegenden Erfindung beschrieben. Bei vielen Anwendungen ist es wünschenswert, ein Taktsignal zu erzeugen, welches eine definierte Phasenbeziehung und eine definierte Frequenzbeziehung zu einem Synchronisationssignal aufweist. Ein typisches Beispiel hierfür ist der Abtasttakt für eine analoge Videoschnittstelle. In dieser Situation wird normalerweise ein horizontales Synchronisationssignal pro Zeile bereitgestellt. Die Pixelfrequenz ist ein definiertes ganzzahliges Vielfaches dieses Abtasttaktes. Das Synchronisationssignal und der Pixeltakt sind nicht notwendigerweise in Phase, und die Phase muss auch durch einen Anwender einstellbar sein.

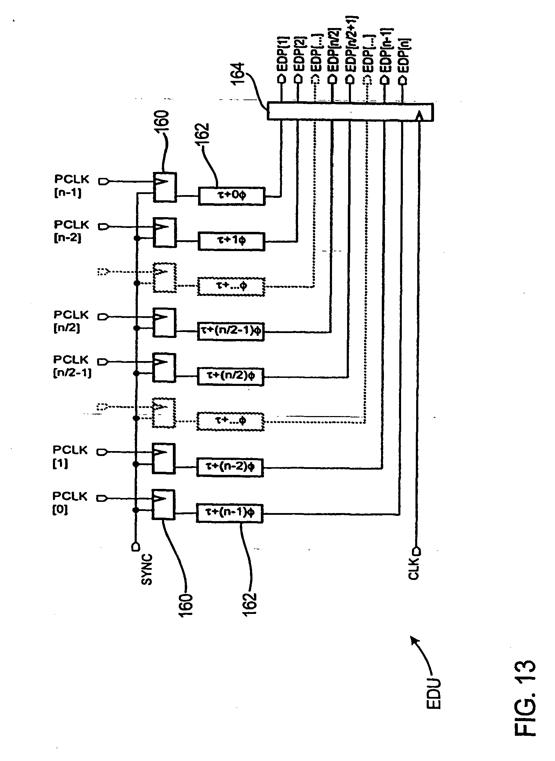

Gemäß dem beschriebenen Ausführungsbeispiel müssen zunächst die Flanken in dem Synchronisationssignal bestimmt werden, um ein Flankenmuster zu erhalten. Hierfür ist eine Flankenerfassungseinheit EDU (EDU = Edge Detection Unit) vorgesehen, die in Fig. 13 gemäß einem bevorzugten Ausführungsbeispiel dargestellt ist. Die Kantenerfassungseinheit empfängt das Synchronisationssignal SYNC, welches einer Mehrzahl von Zwischenspeichern 160 zugeführt wird. Jeder der Zwischenspeicher 160 empfängt eines der Taktsignale PCLK[]. Ähnlich wie in Fig. 3 sind auch hier Verzögerungselemente 162 vorgesehen, welche die von den Speichern 160 ausgegebenen Signale gemäß einer vorbestimmten Verzögerung verzögern und an einen Ausgangspuffer 164 weitergeben, der ferner das Mastertaktsignal CLK empfängt. Der Ausgangspuffer 164 stellt an dessen Ausgang die Signale EDP[] bereit. Mit dem Mehrfach-Phasen-Taktsignal ist es einfach möglich, die zeitliche Position von Signaländerungen in dem Synchronisationssignal zu messen.

Für jeden Mastertaktsignalzyklus wird das Synchronisationssignal mit allen Taktsignalen in den Speichern 160 zwischengespeichert, und die zwischengespeicherten Ergebnisse werden unter Verwendung der Verzögerungselemente 162, die beispielsweise die gleichen Elemente, die in Fig. 3 mit 110 bezeichnet wurden, sein könnten, in zeitlicher Anordnung ausgerichtet.

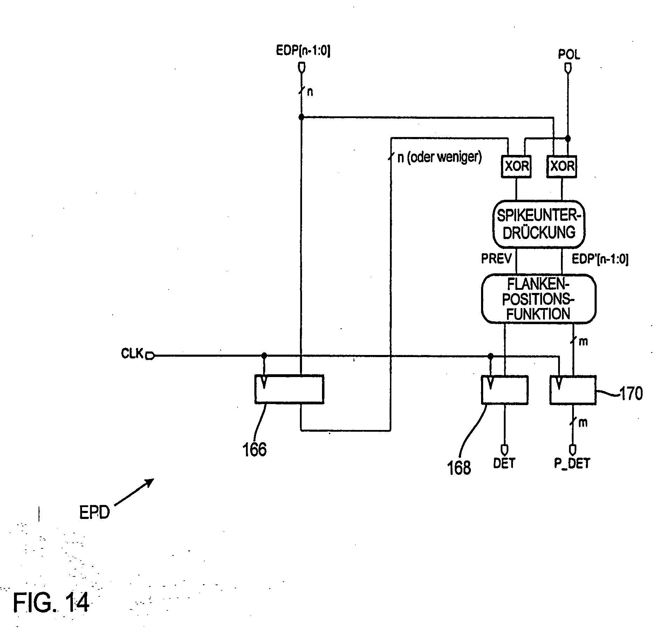

Das zwischengespeicherte Muster reflektiert das Signalverhalten innerhalb des vorhergehenden Mastertaktzyklus mit der bereitgestellten Phasenauflösung. Dieses Muster, zusammen mit dem freilaufenden Mastertaktsignalzähler ermöglicht es, dem Auftreten von Signaländerungen Zeitstempel zuzuordnen. Unter Verwendung des in Fig. 14 beispielhaft gezeigten Flankenpositionsdecoders EPD (EPD = Edge Position Decoder) kann das durch die Kantenerfassungseinheit EDU erzeugte Flankenmuster hinsichtlich einer Flanke mit einer gewünschten Polarität POL untersucht werden. Der Flankenpositionsdecoder empfängt hierfür zum einen das Flankenmuster EPD[] sowie ein die Polarität anzeigendes Signal POL. Die in Fig. 14 gezeigte Flankenpositionsfunktion sucht lediglich nach positiven Flanken, jedoch können mit einer einfachen Invertierung des Eingangsmusters auch negative Flanken gesucht werden. Die Spike-Unterdrückung unterdrückt vorübergehende Änderungen des Eingangssignals, so lange diese unterhalb einer vorbestimmten Schwelle sind. Dies erfordert es, dass der Verlauf des Signals in dem vorhergehenden Zyklus bekannt ist, was durch das Register 166 sichergestellt ist. Über die Zwischenspeicher 168 und 170 werden die Signale DET bzw. P_DET ausgegeben.

In der nachfolgenden Tabelle ist ein Beispiel für die Flankenpositionsfunktion wiedergegeben.

| PREV | EDP[0:n-1] | P DET | DET |
|---|---|---|---|
| 0 | $(1xxx..xxx)_2$ | 0 | 1 |
| x | $(01xx..xxx)_2$ | 1 | 1 |
| x | $(x01x..xxx)_2$ | 2 | 1 |
| x | ... | ... | 1 |
| x | $(xxxx..01x)_2$ | n-2 | 1 |
| x | $(xxxx..x01)_2$ | n-1 | 1 |
| sonstige | | x | 0 |

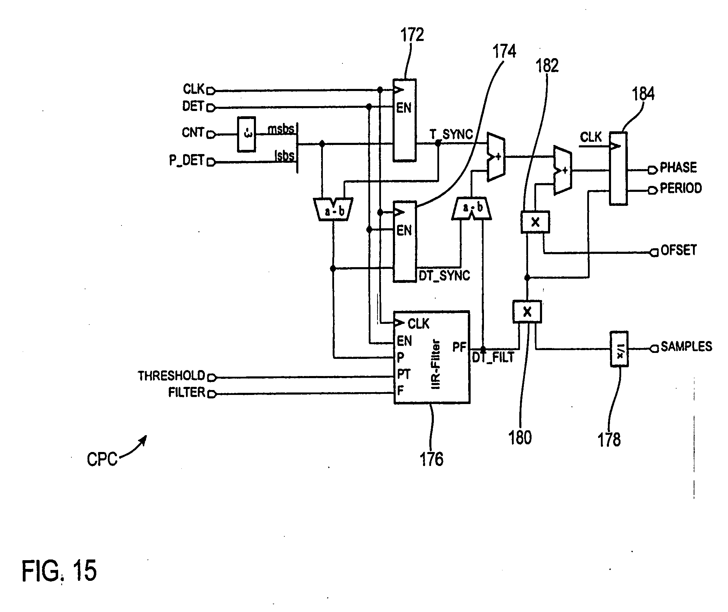

Sobald die genauen Zeitstempel der aufeinanderfolgenden Flanken des Synchronisationssignals bekannt sind, können die geeigneten Parameter für den synchronen Ausgangstakt unter Verwendung des in Fig. 15 gezeigten Taktparameterberechners CPC (CPC = Clock Parameter Calculator) berechnet werden.

Die Messung der Synchronisationsflanke fand drei Zyklen vorher statt, so dass der derzeitige Zählwert korrigiert werden muss. Der Zeitstempel für das vorhergehende Synchronisationsereignis wird als T_SYNC im Register 172 gespeichert. Mit jedem neuen Synchronisationsereignis wird die Differenz zwischen den Zeitstempeln, oder mit anderen Worten die Periode des Synchronisationssignals berechnet und als Signal DT_SYNC im Speicher 174 gespeichert. Überdies wird die gemessene Periode unter Verwendung eines infiniten Impulsantwortfilters 176 gefiltert, um das Filterausgangssignal DT_FILT zu erhalten. Dies reduziert die Empfindlichkeit der Schaltung gegenüber Jitter in dem Synchronisationssignal.

Die genaue Position des Synchronisationsereignisses (T_SYNC) wird durch die Differenz zwischen der gemessenen Synchronisationsperiode und einer idealen (gefilterten) Synchronisationsperiode korrigiert. Das erste Taktsignal sei mit einer definierten Verschiebung (Signal OFSET) von dem idealen (korrigierten) Synchronisationsereigniszeitstempel synthetisiert.

Die gefilterte Synchronisationsperiode (Signal DT_FILT) wird ferner verwendet, um die Periode des zu synthetisierenden Taktsignals (Signal PERIOD) zu bestimmen. Dies wird wirksam dadurch erreicht, dass die Synchronisationsperiode durch die Anzahl von synthetisierten Taktsignalen, die zwischen zwei aufeinanderfolgenden Synchronisationsereignissen (Signal SAMPLES) auftreten, dividiert wird, wie dies durch die Blöcke 178 und 180 in Fig. 15 gezeigt ist.

Hinsichtlich der in Fig. 15 dargestellten Schaltung des Taktsignalparameterberechners ist darauf hinzuweisen, dass dieser nicht für hohe Mastertaktsignalgeschwindigkeiten optimiert ist. Insbesondere bewirken die zwei Multiplizierer 180 und 182 eine signifikante Verzögerung. Das Ausgangs-Flip-Flop 184 kann jedoch deren Ergebnisse zu einem späteren Zyklus zwischenspeichern, oder sie können pipelinemäßig ausgebaut sein. In Anwendungen, bei denen sich die Synchronisationsperiode nur moderat ändert, kann das Signal DT_FILT der vorhergehenden Messung verwendet werden, um Zeit für die Berechnung zu gewinnen. Die reziproke Anzahl von Abtastwerten (Signal SAMPLES) kann softwaremäßig vorab berechnet werden.

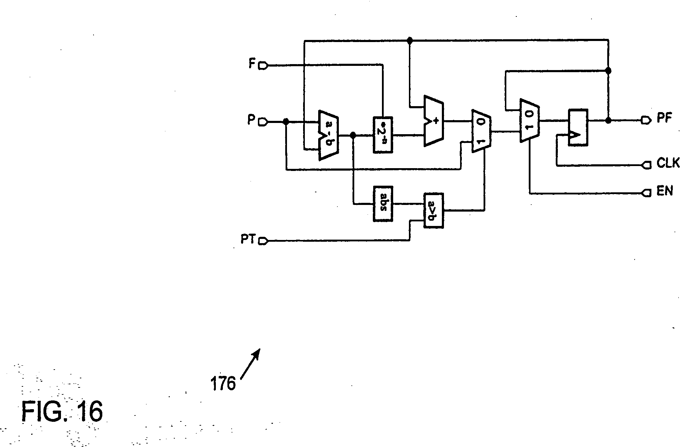

Das Filter 176 für die Synchronisationsperiode kann in verschiedenen Formen ausgebildet sein, die den Verlauf der Periodenmessungen ausnutzen. Der Typ des erforderlichen Filters hängt sehr stark von der Anwendung und der Stabilität des ankommenden Synchronisationssignals ab. Fig. 16 zeigt ein Beispiel für ein IIR-Filter 176, welches eine einfache Implementierung des Filters darstellt, die eine gewichtete Addition der gefilterten Messung und der derzeitigen Messung gemäß folgender Gleichung durchführt:

$$PF_{n+1} = \begin{cases} \dfrac{P + (2^F - 1)PF_n}{2^F} & \text{if } |P - PF_n| \leq PT \\ P & \text{if } |P - PF_n| > PT \end{cases}$$

Wenn die gemessene Periode sich um mehr als eine programmierbare Schwelle THRESHOLD ändert, wird das Filter 176 sofort wirksam, so dass sich als ein Ergebnis der Jitter unterdrücken lässt und Frequenzänderungen ohne Verzögerung gefolgt wird.

Gemäß dem hier beschriebenen Ausführungsbeispiel wird nun anstelle des anhand der Fig. 6 beschriebenen primären Flankeninterpolators ein neuer primärer Flankeninterpolator PEI2 für die Taktsignalsynchronisation verwendet. Die Schaltung erzeugt immer eine primäre Flanke, zum Zeitpunkt des Erhalts der Zeitstempels PHASE, und schaltet dann auf die neue Taktsignalperiode. Bevor dieser Zeitstempel erhalten wird, ist die vorhergehende Taktsignalperiode aktiv. Ferner werden aufeinanderfolgende Taktflanken mit dem Wert des Signals PHASE verglichen. Um die Einfügung einer kürzeren Taktperiode unmittelbar vor dem Empfang des Zeitstempels PHASE zu vermeiden, werden solche Flanken ausgelassen. Es sei darauf hingewiesen, dass dieser synchronisierbare Phasenflankeninterpolator ein Taktsignal mit einem festen Tastverhältnis von 50% erzeugt.

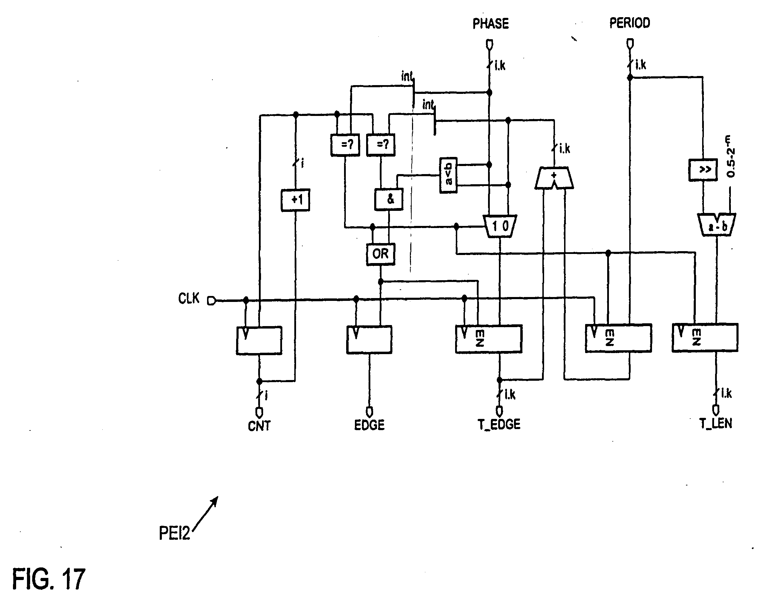

Wie aus einem Vergleich mit den Fig. 17 und 6 zu entnehmen ist, werden durch den neuen Interpolator die gleichen Ausgangssignale erzeugt, wie beim Interpolator aus Fig. 6, die dann nachfolgend den bereits oben beschriebenen Einheiten SEC, PEU und POU zur Erzeugung des Taktsignals CLKOUT bereitgestellt werden.

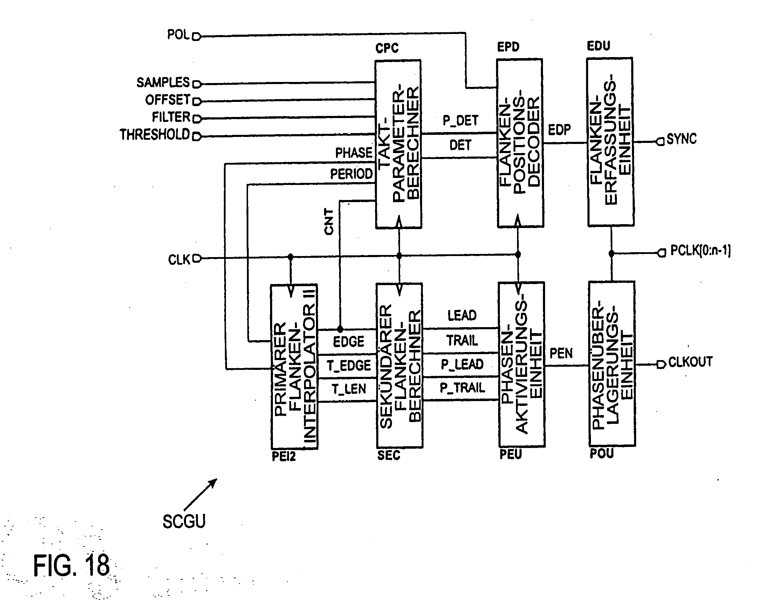

In Fig. 18 ist ein Beispiel für eine synchrone Taktsignalerzeugungseinheit SCGU (SCGU = Synchronous Clock Generation Unit) gemäß dem oben beschriebenen Ausführungsbeispiel dargestellt. Die in den vorhergehenden Figuren beschriebenen Elemente sind zu der Gesamteinheit SCGU zusammengefasst, wobei in Fig. 18 diese jeweiligen Elemente bzw. Einheiten empfangenen und ausgegebenen Signale dargestellt sind. Die oben beschriebenen Blöcke oder Einheiten sind zu den in Fig. 18 dargestellten digitalen synchronen Taktgenerator kombiniert. Eine Synchronisationsflanke wird erfasst und ein Zeitstempel wird dem Synchronisationsereignis zugeordnet. Anschließend wird die Periode zwischen den Synchronisationsereignissen berechnet. Mit diesen Informationen werden die Parameter für den zu synthetisierenden Takt bestimmt. Unter Kenntnis dieser Parameter kann die oben beschriebene Schaltung für den freilaufenden Taktgenerator verwendet werden, mit einer geringfügigen Änderung hinsichtlich der Verwendung des primären Flankeninterpolators.

Bei einigen Anwendungen kann es zusätzlich erforderlich sein, ein ideales Synchronisationssignal zu rekonstruieren, das perfekt mit dem synthetisierten Taktsignalen ausgerichtet und ohne Jitter ist. Dies kann durch Verwendung einer weiteren Phasenüberlagerungseinheit zusammen mit einiger weiterer digitaler Signalverarbeitung erreicht werden. Mittels des Synchronisationszeitstempels, dessen Periode und dessen Abtastwertverschiebung kann ein synthetisches Synchronisationssignal einfach als weiterer Takt erzeugt werden.

Jeder Zeitstempel zwischen zwei Synchronisationsereignissen muss gleich sein, so dass die Ganzzahlgenauigkeit des Interpolators durch die minimale Synchronisationsfrequenz bestimmt ist.

$$i \geq \log_2\left(\frac{f_{CLK}}{f_{CLKOUT,MIN}}\right)$$

Zwischen zwei Synchronisationsereignissen läuft der Synchronisationstakt frei und erfährt einen Phasenfehler ($\Delta t$), der eine Funktion der Anzahl von interpolierten Taktperioden und der Bruchteilauflösung des Interpolators ist.

$$\Delta t = \frac{f_{CLK,MAX}}{2^k \cdot f_{CLK} \cdot f_{SYNC,MIN}}$$

Die Bruchteilinterpolationsgenauigkeit bestimmt sich wie folgt:

$$k \geq \log_2\left(\frac{f_{\text{CLKOUT,MAX}}}{\Delta t \cdot f_{\text{CLK}} \cdot \Delta f_{\text{SYNC,MAX}}}\right) \qquad \text{für } \Delta t = \Phi$$

$$k \geq \log_2\left(\frac{f_{\text{CLKOUT,MAX}}}{\Delta t \cdot f_{\text{CLK}} \cdot \Delta f_{\text{SYNC,MAX}}}\right) + m$$

Beispielhaft sei eine Graphikanwendung betrachtet. Hier soll ein Pixelabtasttakt (ACLK, 25...210MHz) aus einem horizontalen Synchronisationssignal (HSYNC, 15...115kHz) erzeugt werden, wobei ein Mastertakt mit 250MHz und 32 Phasen verwendet wird. Hier gilt:

$$i \geq \log_2\left(\frac{f_{\text{CLK}}}{f_{\text{CLKOUT,MIN}}}\right) = \log_2\left(\frac{250\text{MHz}}{0{,}015\text{MHz}}\right) \approx 14{,}02 \rightarrow i = 15$$

$$k \geq \log_2\left(\frac{f_{\text{CLKOUT,MAX}}}{\Delta t \cdot f_{\text{CLK}} \cdot \Delta f_{\text{SYNC,MAX}}}\right) + m = \log_2\left(\frac{210\text{MHz}}{0{,}015\text{MHz}}\right) + 5 \approx 18{,}77 \rightarrow k = 19$$

Der Flankeninterpolator muss somit 15 ganzzahlige Bits und 19 Bruchteilbits, also 34 Bits im Ganzen, umfassen.

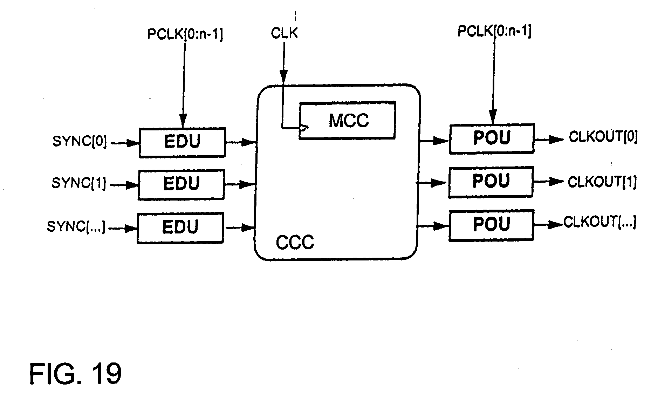

Fig. 19 zeigt ein Blockdiagramm eines System zur beliebigen Taktsynthese (Arbitrary Clock Synthesis) gemäß einem Ausführungsbeispiel der vorliegenden Erfindung. Dieses System schafft die Möglichkeit, eine Mehrzahl beliebiger Takt zu erzeugen (Arbitrary Clock Synthesis).

Das System umfasst eine Mehrzahl von Flankenerfassungseinheiten EDU, die jeweils ein externes Synchronisationssignal SYNC[] sowie die von der DLL (Fig. 1) auf der Grundlage des Mastertaktsignals erzeugten Taktsignale PCLK[] empfangen. Die Ausgangssignale der Flankenerfassungseinheiten EDU werden einer Taktberechnungsschaltung CCC (CCC = Clock Calculation Circuitry) zugeführt, die ferner den Mastertakt CLK empfängt. Die CCC umfasst einen Mastertaktzähler MCC (MCC = Master Clock Counter). Die CCC gibt die erzeugten Ausgangssignale an eine Mehrzahl von Phasenüberlagerungseinheiten POU aus, die basierend auf diesen Signalen sowie auf den Taktsignalen PCLK[] die erwünschten Taktsignale CLKOUT[] (eines oder mehrere) erzeugt.

Gemäß diesem allgemeineren Ansatz kann eine beliebige Anzahl von Takten CLKOUT[] von demselben Multiphasentaktsignal CLK synthetisiert werden, wobei der Zeitverlauf des Taktausgangs von einer beliebigen Anzahl von Synchronisationssignalen SYNC[] abhängen kann. Bei diesem Ausführungsbeispiel ist der Mastertaktzähler MCC vorgesehen, der bei jedem Mastertaktzyklus inkrementiert wird, wodurch ein gemeinsames Zeitreferenzsystem gebildet wird. Durch Verwendung dieser Referenz können Zeitstempel jedem tatsächlichen oder auch jedem hypothetischen Ereignis (z.B. steigende oder fallende Flanke) in dem gesamten Takterzeugungssystem zugeordnet werden. Um die zeitliche Position des Ereignisses zwischen diskreten Mastertaktereignissen auszudrücken, können Bruchzahlen mit nahezu unbeschränkter Genauigkeit verwendet werden.

Zeitstempel werden steigenden Flanken und fallenden Flanken des externen Synchronisationsereignis zugeordnet, werden jedoch auch Flankenpositionen von potenziell komplexen und unregelmäßigen Taktsignalen zugeordnet. Der abstrakte Begriff "Zeitstempel" ermöglicht die arithmetische Verarbeitung der Ereignisse. Beliebige Taktformen können damit berechnet werden, und Taktsignale mit vorbestimmter Beziehung untereinander und zu externen Ereignissen können einfach erzeugt werden.

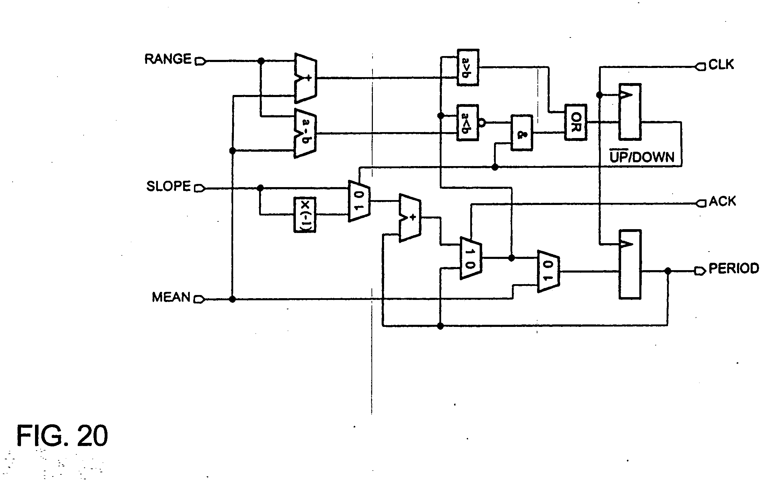

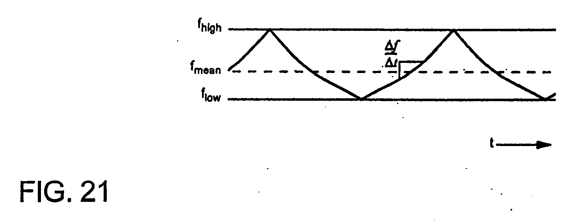

Nachfolgend wird anhand der Fig. 20 und 21 ein weiteres Ausführungsbeispiel der vorliegenden Erfindung beschrieben. Gemäß diesem Ausführungsbeispiel erfolgt eine Spread-Spektrum Taktsignalsynthese. Die Periode des erzeugten Taktsignals kann auf einfache Art und Weise im digitalen Bereich moduliert werden. Eine Schaltung ist vorgesehen, wie sie in Fig. 20 gezeigt ist, welche dazu dient die synthetisierte Taktsignalperiode zwischen zwei Extremwerten mit einer definierbaren Steigung zu bewegen. Die in Fig. 20 gezeigte Schaltung ist ein Spread-Spektruminterpolator, der als Eingangssignal das Taktsignal empfängt sowie ein den Bereich angebendes Signal RANGE, ein die Steigung angebendes Signal SLOPE und ein den Mittelwert angebendes Signal MEAN. Nach jedem erzeugten Taktzyklus wird die Periode um einen Periodendeltawert (SLOPE) inkrementiert, bis die Periode eine obere Grenze (MEAN + RANGE) erreicht. Nach dem Erreichen der oberen Grenze wird die aktuelle Taktperiode wieder dekrementiert, bis dieselbe eine untere Grenze (MEAN - RANGE) erreicht. Dies wird zyklisch wiederholt, so dass sich das in Fig. 21 wiedergegebene Sweep-Verhalten ergibt.

Die Frequenz zeigt nicht-lineare Veränderungen über der Zeit, jedoch ist diese, so lange der Modulationsbereich klein ist (RANGE << als MEAN), ist dieser nahezu linear, Gelten die nachfolgenden Berechnungsvorschriften:

$$f_{mean} = \frac{1}{t_{mean}} \qquad f_{high} = \frac{1}{t_{mean} - t_{range}} \qquad f_{low} = \frac{1}{t_{mean} + t_{range}} \; ,$$

$$\frac{\Delta f}{\Delta t} \cong \frac{t_{slope}}{(t_{mean})^3} = t_{slope} \cdot (f_{mean})^3$$

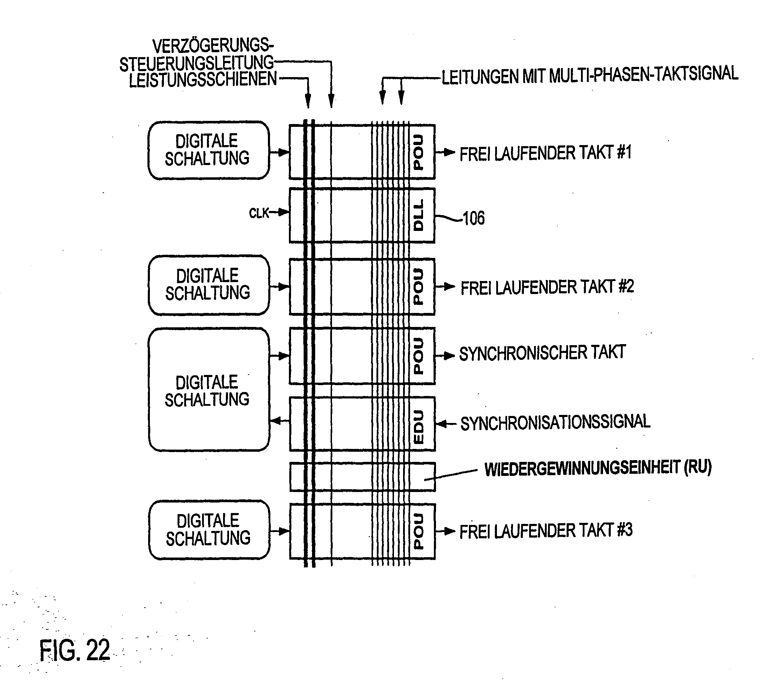

Anhand der Fig. 22 wird nachfolgend eine mögliche Implementierung des erfindungsgemäßen Verfahrens und der erfindungsgemäßen Vorrichtung in modularer Bauweise näher erläutert. Die digitale Taktsignalsynthese wird am besten unter Verwendung eines modularen Ansatzes implementiert. Die DLL-Schaltung 106, die Phasenüberlagerungseinheiten POU und die Flankenerfassungseinheit EDU sollten miteinander ausgerichtet sein, um eine kaskadische Anordnung derselben zu ermöglichen. Die DLL-Schaltung 106 stellt die Multi-Phasen-Taktsignale und die Steuerungsspannung für die Verzögerungselemente bereit. Alle Module verwenden eine gemeinsame Leistungsschiene (power rail).

Es wird eine maximale Belastung für die Multi-Phasen-Taktsignale und die Verzögerungssteuerungsspannung existieren, so dass zur Verbindung einer Mehrzahl von Phasenüberlagerungseinheiten POU und Flankenerfassungseinheiten EDU eine Wiedergewinnungseinheit RU (RU = Recovery Unit) eingefügt werden kann. Ferner kann vorgesehen sein, zusätzliche Module auf der anderen Seite der DLL 106 vorzusehen.

Bei der Phasenüberlagerungseinheit PDU und der Flankenerfassungseinheit EDU handelt es sich im Prinzip um digitale Einheiten, jedoch ist für eine genaue Verzögerungssteuerung eine geeignete Anpassung an die DLL-Schaltung 106 gemäß analogen Entwicklungsregeln vorteilhaft.

**Patentansprüche**

1. Verfahren zum Erzeugen eines Taktsignals (CLKOUT) mit vorbestimmten Taktsignaleigenschaften (PERIOD, DUTY, PHASE), mit folgenden Schritten:

(a) Bereitstellen einer Mehrzahl von Taktsignalen (PCLK[n-1:0]) mit im wesentlichen gleicher Frequenz und jeweils verschiedenen Phasenbeziehungen (φ) bezüglich eines Mastertaktsignals (CLK); und
(b) basierend auf einem Steuersignal (PEN[]), das abhängig von dem zu erzeugenden Taktsignal (CLKOUT) bereitgestellt wird, Auswählen vorbestimmter Taktsignale aus der Mehrzahl von bereitgestellten Taktsignalen (PLK[n-1:0]) und Zusammenfassen der ausgewählten Taktsignale, um das Taktsignal (CLKOUT) zu erzeugen;

**dadurch gekennzeichnet,**

**daß** das Steuersignal eine Mehrzahl von Aktivierungssignalen (PEN[n-1:0]) umfasst, wobei ein Aktivierungssignal (PEN[]) für jedes der Mehrzahl von Taktsignalen (PCLK[]) vorgesehen ist, und wobei die Aktivierungssignale (PEN[]) verzögert bereitgestellt werden, um eine Ausrichtung derselben einzustellen, um die vorbestimmten Taktsignaleigenschaften des zu erzeugenden Taktsignals (CLKOUT) zu erhalten.

2. Verfahren nach Anspruch 1, bei dem im Schritt (b) die Pulse mit hohem logischen Pegel der ausgewählten Taktsignale (PCLK) zusammengefasst werden, um das Taktsignal (CLKOUT) mit einem Puls mit hohem logischen Pegel und vorbestimmter Pulsdauer zu erzeugen.

3. Verfahren nach Anspruch 1 oder 2, bei dem abhängig von dem bereitgestellten Steuersignal (PEN) die Dauer der einzelnen Pulse mit hohem logischen Pegel, die Dauer der einzelnen Pulse mit niedrigem logischen Pegel und die Form des Pulszuges des zu erzeugenden Taktsignals (CLKOUT) gesteuert wird.

4. Verfahren nach einem der Ansprüche 1 bis 3, bei dem die kürzeste Dauer eines Pulses mit hohem logischen Pegel durch die Dauer des Pulses mit hohem logischen Pegel des Mastertaktsignals (CLK) festgelegt ist, und bei dem die kürzeste Dauer eines Pulses mit niedrigem logischen Pegel durch die Phasenauflösung der Mehrzahl von Taktsignalen (PCLK[n-1 : 0]) bestimmt ist.

5. Verfahren nach einem der Ansprüche 1 bis 4, bei dem der Schritt (b) das Bereitstellen einer Aktivierungssignalsequenz (PEN) umfasst, um ein periodisches Taktsignal mit vorbestimmter Frequenz und vorbestimmtem Tastverhältnis zu erzeugen.

6. Verfahren nach Anspruch 5, bei dem der Schritt des Bereitstellens der Aktivierungssignalsequenz (PEN) folgende Schritte umfasst:

   - Bestimmen einer Position der führenden Flanke in dem zu erzeugenden Taktsignal;
   - Bestimmen einer Position der nachfolgenden Flanke in dem zu erzeugenden Taktsignal, ausgehend von der Position der führenden Flanke; und
   - basierend auf der Position der führenden Flanke und auf der Position der nachfolgenden Flanke, Erzeugen der Aktivierungssignalsequenz (PEN).

7. Verfahren nach Anspruch 6, bei dem das zu erzeugende Taktsignal (CLKOUT) eine definierte Phasen- und Frequenzbeziehung zu einem Synchronisationssignal (SYNCH) aufweist, mit folgenden Schritten vor dem Bestimmen der Position einer führenden Flanke:

   - Erfassen von Signalzustandsänderungen in dem Synchronisationssignal (SYNC), um ein Flankenmuster zu erzeugen;
   - Bestimmen von Flanken mit einer vorbestimmten Polarität (POL) in dem Flankenmuster; und
   - basierend auf den bestimmten Flanken des Synchronisationssignal (SYNC), Bestimmen der Periode und der Phase des zu erzeugenden synchronisierten Taktsignals.

8. Verfahren nach einem der Ansprüche 1 bis 7, bei dem die Periode des erzeugten Taktsignals (CLKOUT) moduliert wird, um ein Spread-Spektrum Taktsignal zu erhalten, wobei das Verfahren nach jedem erzeugten Taktsignalzyklus folgende Schritte umfasst:

   - Inkrementieren der Periode um einen vorbestimmten Wert, bis eine obere Grenze erreicht ist;
   - Dekrementieren der Periode um einen vorbestimmten Wert, bis eine untere Grenze erreicht ist; und
   - zyklisches Wiederholen des Inkrementierens und des Dekrementierens.

9. Verfahren nach einem der Ansprüche 1 bis 8, bei dem bei der Erzeugung des Taktsignals ein Zeitstempel oder mehrere Zeitstempel erzeugt werden.

10. Verfahren nach Anspruch 9, bei dem ein Zeitstempel bei einer steigenden Flanke und/oder bei einer fallenden Flanke des erzeugten Taktsignals erzeugt wird.

11. Verfahren nach Anspruch 9 oder 10, bei dem basierend auf dem Mastertaktsignal ein Zeitstempel oder mehrere Zeitstempel erzeugt werden, die einem oder mehreren externen Synchronisationssignalen und/oder dem erzeugten Taktsignal zugeordnet werden.

12. Verfahren nach Anspruch 11, bei dem eine Beziehung zwischen einer oder mehreren Flanken des erzeugten Taktsignals und den Flanken des externen Synchronisationssignals basierend auf den Zeitstempeln geregelt wird, die diesen Signalen zugeordnet sind.

13. Verfahren nach einem der Ansprüche 1 bis 12, bei dem basierend auf den im Schritt (a) bereitgestellten Taktsignalen eine Mehrzahl von unabhängigen Taktsignalen erzeugt wird.

14. Vorrichtung zum Erzeugen eines Taktsignals (CLKOUT) mit vorbestimmten Taktsignaleigenschaften (PERIOD, DUTY, PHASE), mit:

einem Multi-Phasen-Taktgenerator (106) zum Bereitstellen einer Mehrzahl von Taktsignalen (PCLK[n-1:0] mit im wesentlichen gleicher Frequenz und jeweils verschiedenen Phasenbeziehungen ($\phi$) bezüglich eines Mastertaktsignals (CLK); und

einer Phasenüberlagerungseinheit (POU), die basierend auf einem Steuersignal (PEN), das abhängig von dem zu erzeugenden Taktsignal (CLKOUT) bereitgestellt wird, vorbestimmte Taktsignale aus der Mehrzahl von bereitge stellten Taktsignalen (PCLK) auswählt und die ausgewählten Taktsignale zusammenfasst, um das Taktsignal (CLKOUT) zu erzeugen;

**dadurch gekennzeichnet,**

**daß** das Steuersignal eine Mehrzahl von Aktivierungssignalen (PEN[n-1:0]) umfasst, wobei ein Aktivierungssignal (PEN[]) für jedes der Mehrzahl von Taktsignalen (PCLK[]) vorgesehen ist, und wobei die Aktivierungssignale (PEN[]) verzögert bereitgestellt werden, um eine Ausrichtung derselben einzustellen, um die vorbestimmten Taktsignaleigenschaften des zu erzeugenden Taktsignals (CLKOUT) zu erhalten.

15. Vorrichtung nach Anspruch 14, mit:

einem primären Flankeninterpolator (PEI; PEI2) zum Bestimmen einer Position der führenden Flanke in dem zu erzeugenden Taktsignal;

einem sekundären Flankenberechner (SEC) zum Bestimmen einer Position der nachfolgenden Flanke in dem zu erzeugenden Taktsignal, ausgehend von der Position der führenden Flanke; und

einer Phasenaktivierungseinheit (PEU), um basierend auf der Position der führenden Flanke und auf der Position der nachfolgenden Flanke eine Aktivierungssignalsequenz zu erzeugen.

16. Vorrichtung nach Anspruch 15, bei dem das zu erzeugende Taktsignal eine definierte Phasen- und Frequenzbeziehung zu einem Synchronisationssignal (SYNC) aufweist, mit:

einer Flankenerfassungseinheit (EDU), um Signalzustandsänderungen in dem Synchronisationssignal (SYNC) zu erfassen, um ein Flankenmuster zu erzeugen;

einem Flankenpositionsdecoder (EPD), um Flanken mit einer vorbestimmten Polarität (POL) in dem Flankenmuster zu bestimmen; und

einem Taktparameterberechner (CPC), um basierend auf den bestimmten Flanken des Synchronisationssignals (SYNC) die Periode und die Phase für das zu erzeugende synchronisierte Taktsignal zu bestimmen.

17. Vorrichtung nach einem der Ansprüche 14 bis 16, bei dem die Periode des erzeugten Taktsignals moduliert wird, um ein Spread-Spektrumtaktsignal zu erhalten, mit einem Spread-Spektruminterpolator, um nach jedem erzeugten Taktsignalzyklus die Periode um einen vorbestimmten Wert zu inkrementieren, bis eine obere Grenze erreicht ist, und die Periode um einen vorbestimmten Wert, bis eine untere Grenze erreicht ist zu dekrementieren.

18. Vorrichtung nach einem der Ansprüche 14 bis 17, mit eine Einrichtung (CCC) zum Erzeugen eines Zeitstempels oder mehrerer Zeitstempel.

19. Vorrichtung nach Anspruch 18, bei der die Einrichtung (CCC) zum Erzeugen eines Zeitstempels oder mehrerer Zeitstempel eine Taktberechnungsschaltung (CCC) umfasst, die den Mastertakt CLK empfängt und einen Mastertaktzähler (MCC) aufweist, wobei die Taktberechnungsschaltung (CCC) basierend auf dem Mastertaktsignal einen Zeitstempel oder mehrere Zeitstempel erzeugt, die einem oder mehreren externen Synchronisationssignalen (SYNC[]) und/oder dem erzeugten Taktsignal (CLKOUT) zugeordnet werden.

**Claims**

1. A method for generating a clock signal (CLKOUT) having predetermined clock signal properties (PERIOD, DUTY, PHASE), comprising the following steps:

(a) providing a plurality of clock signals (PCLK[n-1:0]) having substantially the same frequency and respectively different phase relations each ($\Phi$) with respect to a master clock signal (CLK); and

(b) based on a control signal (PEN[]), which is provided depending on the clock signal (CLKOUT) to be generated, selecting predetermined clock signals from the plurality of provided clock signals (PLK[n-1:0]) and combining the selected clock signals to generate the clock signal (CLKOUT);

**characterized in that**
the control signal includes a plurality of enable signals (PEN[n-1:0]), wherein an enable signal (PEN[]) is provided for each of the plurality of clock signals (PEN[]), and wherein the enable signals (PEN[]) are provided delayed in order to set an alignment of the same to obtain the predetermined clock signal properties of the clock signal (CLKOUT) to be generated.

2. The method according to claim 1, wherein in step (b) the pulses with a high logic level of the selected clock signals (PCLK) are combined to generate the clock signal (CLKOUT) with a pulse with a high logic level and a predetermined pulse duration.

3. The method according to claim 1 or 2, wherein depending on the provided control signal (PEN) the duration of the individual pulses having a high logic level, the duration of the individual pulses having a low logic level and the form of the pulse train of the clock signal (CLKOUT) to be generated is controlled.

4. The method according to one of claims 1 to 3, wherein the shortest duration of a pulse with a high logic level is determined by the duration of the pulse with a high logic level of the master clock signal (CLK), and wherein the shortest duration of a pulse with a low logic level is determined by the phase resolution of the plurality of clock signals (PCLK[n-1:0]).

5. The method according to one of claims 1 to 4, wherein step (b) includes providing an enable signal sequence (PEN), in order to generate a periodic clock signal having a predetermined frequency and a predetermined duty cycle.

6. The method according to claim 6, wherein the step of providing the enable signal sequence (PEN) includes the following steps:

   - determining a position of the leading edge in the clock signal to be generated;
   - determining a position of the trailing edge in the clock signal to be generated based on the position of the leading edge; and
   - generating the enable signal sequence (PEN) based on the position of the leading edge and of the position of the trailing edge.

7. The method according to claim 6, wherein the clock signal (CLKOUT) to be generated comprises a defined phase and frequency relation to a synchronization signal (SYNCH), with the following steps prior to determining the position of a leading edge:

   - detecting signal state changes in the synchronization signal (SYNC) to generate an edge pattern;
   - determining edges having a predetermined polarity (POL) in the edge pattern; and
   - determining the period and the phase of the synchronized clock signal to be generated based on the determined edges of the synchronization signal (SYNC).

8. The method according to one of claims 1 to 7, wherein the period of the generated clock signal (CLKOUT) is modulated in order to obtain a spread spectrum clock signal, wherein the method includes the following steps after each generated clock signal cycle:

   - incrementing the period by a predetermined value until an upper limit is reached;
   - decrementing the period by a predetermined value until a lower limit is reached; and
   - cyclic repetition of the incrementing and decrementing.

9. The method according to one of claims 1 to 8, wherein during the generation of the clock signal a time stamp or several time stamps are generated.

10. The method according to claim 9, wherein a time stamp is generated in a rising edge and/or in a falling edge of the generated clock signal.

11. The method according to claim 9 or 10, wherein based on the master clock signal, a time stamp or several time stamps are generated, which are associated with one or several external synchronization signals and/or the generated clock signal.

12. The method according to claim 11, wherein a relation between one or several edges of the generated clock signal and the edges of the external synchronization signal is determined based on the time stamps associated with these signals.

13. The method according to one of claims 1 to 12, wherein based on the clock signals provided in step (a) a plurality of independent clock signals is generated.

14. A device for generating a clock signal (CLKOUT) having predetermined clock signal properties (PERIOD, DUTY, PHASE), comprising:

   a multi-phase clock generator (106) for providing a plurality of clock signals (PCLK[n-1:0]) having substantially the same frequency and respectively different phase relations ($\Phi$) with respect to a master clock signal (CLK); and
   a phase overlay unit (POU), which selects predetermined clock signals from the plurality of provided clock signals (PCLK) based on a control signal (PEN) provided depending on the clock signal (CLKOUT) to be generated, and combines the selected clock signals to generate the clock signal (CLKOUT);

   **characterized in that**
   the control signal includes a plurality of enable signals (PEN[n-1:0]), wherein an enable signal (PEN[]) is provided for each of the plurality of clock signals (PEN[]), and wherein the enable signals (PEN[]) are provided delayed in order to set an alignment of the same to obtain the predetermined clock signal properties of the clock signal (CLKOUT) to be generated.

15. The device according to claim 14, comprising:

   a primary edge interpolator (PEI; PEI2) for determining a position of a leading edge in the clock signal to be generated;
   a secondary edge calculator (SEC) for determining a position of the trailing edge in the clock signal to be generated based on the position of the leading edge; and
   a phase enable unit (PEU) to generate an enable signal sequence based on the position of the leading edge and on the position of the trailing edge.

16. The device according to claim 15, wherein the clock signal to be generated comprises a defined phase and frequency relation to a synchronization signal (SYNC), comprising:

   an edge detection unit (EDU) to detect signal state changes in the synchronization signal (SYNC) in order to generate an edge pattern;
   an edge position decoder (EPD) in order to determine edges with a predetermined polarity (POL) in the edge pattern; and
   a clock parameter calculator (CPC) to determine the period and the phase for the synchronized clock signal to be generated based on the determined edges of the synchronization signal (SYNC).

17. The device according to one of claims 14 to 16, wherein the period of the generated clock signal is modulated in order to obtain a spread spectrum clock signal, comprising
   a spread spectrum interpolator in order to increment the period by a predetermined value after every generated clock signal cycle, until an upper limit is achieved, and to decrement the period by a predetermined value until a lower limit is achieved.

18. The device according to one of claims 14 to 17 comprising a means (CCC) for generating a time stamp or several time stamps.

19. The device according to claim 18, wherein the means (CCC) for generating a time stamp or several time stamps includes a clock calculation circuitry (CCC) receiving the master clock (CLK) and comprising a master clock counter (MCC), wherein the clock calculation circuitry (CCC) generates a time stamp or several time stamps based on the master clock signal, which are associated with one or several external synchronization signals (SYNC[]) and/or the generated clock signal (CLKOUT).

**Revendications**

1. Procédé pour générer un signal d'horloge (CLKOUT) à propriétés de signal d'horloge prédéterminées (PERIOD, DUTY, PHASE), aux étapes suivantes consistant à :

   (a) préparer une pluralité de signaux d'horloge (PCLK[n-1:0]) de fréquence sensiblement identique et chacun de rapports de phase (Φ) différents par rapport à un signal d'horloge principal (CLK) ; et
   (b) sur base d'un signal de commande (PEN[]) préparé en fonction du signal d'horloge (CLKOUT) à générer, sélectionner des signaux d'horloge prédéterminés parmi la pluralité de signaux d'horloge (PLK[n-1:0]) préparés et regrouper les signaux d'horloge sélectionnés, pour générer le signal d'horloge (CLKOUT) ;

   **caractérisé par le fait**
   **que** le Signal de commande comporte une pluralité de signaux d'activation (PEN[n-1:0]), un signal d'activation (PEN[]) étant prévu pour chacun de la pluralité de signaux d'horloge (PCLK[]), et les signaux d'activation (PEN[]) étant préparés temporisés, afin de régler un alignement de ces derniers, pour obtenir les propriétés de signal d'horloge prédéterminées du signal d'horloge (CLKOUT) à générer.

2. Procédé selon la revendication 1, dans lequel, à l'étape (b), les impulsions à haut niveau logique des signaux d'horloge (PCLK) sélectionnés sont regroupées, pour générer le signal d'horloge (CLKOUT) avec une impulsion à haut niveau logique et durée d'impulsion prédéterminée.

3. Procédé selon la revendication 1 ou 2, dans lequel sont réglées en fonction du signal de commande (PEN) préparé la durée des impulsions individuelles à haut niveau logique, la durée des impulsions individuelles à faible niveau logique et la forme du train d'impulsions du signal d'horloge à générer (CLKOOT).

4. Procédé selon l'une des revendications 1 à 3, dans lequel la durée la plus courte d'une impulsion à haut niveau logique est fixée par la durée de l'impulsion à haut niveau logique du signal d'horloge principal (CLK), et dans lequel la durée la plus courte d'une impulsion à faible niveau logique est déterminée par la résolution de phase de la pluralité de signaux d'horloge (PCLK[n=1:0]).

5. Procédé selon l'une des revendications 1 à 4, dans lequel l'étape (b) comporte la préparation d'une séquence de signaux d'activation (PEN), pour générer un signal d'horloge périodique à fréquence prédéterminée et à rapport d'horloge prédéterminé.

6. Procédé selon la revendication 5, dans lequel l'étape de préparation de la séquence de signaux d'activation (PEN) comporte les étapes suivantes consistant à :

   - déterminer une position du flanc d'attaque dans le signal d'horloge à générer ;
   - déterminer une position du flanc suivant dans le signal d'horloge à générer, partant de la position du flanc d'attaque ; et
   - sur base de la position du flanc d'attaque et de la position du flanc suivant, générer la séquence de signaux d'activation (PEN).

7. Procédé selon la revendication 6, dans lequel le signal d'horloge (CLKOUT) à générer présente un rapport de phase et de fréquence défini avec un signal de synchronisation (SYNCH), aux étapes suivantes, avant la détermination de la position d'un flanc d'attaque, consistant à :

   - détecter des variations d'état de signal dans le signal de synchronisation (SYNC), pour générer un modèle de flanc ;
   - déterminer des flancs à polarité (POL) prédéterminée dans le modèle de flanc ; et
   - sur base des flancs déterminés du signal de synchronisation (SYNC), déterminer la période et la phase du signal d'horloge synchronisé à générer.

8. Procédé selon l'une des revendications 1 à 7, dans lequel la période du signal d'horloge généré (CLKOUT) est modulée, pour obtenir un signal d'horloge à étalement du spectre, le procédé comportant, après chaque cycle de signal d'horloge généré, les étapes suivantes consistant à :

- incrémenter la période d'une valeur prédéterminée, jusqu'à ce que soit atteinte une limite supérieure ;
- décrémenter la période d'une valeur prédéterminée, jusqu'à ce que soit atteinte une limite inférieure ; et
- répéter de manière cyclique l'incrémentation et la décrémentation.

9. Procédé selon l'une des revendications 1 à 8, dans lequel il est généré, lors de la génération du signal d'horloge, une estampille ou plusieurs estampilles.

10. Procédé selon la revendication 9, dans lequel une estampille est générée à un flanc montant et/ou à un flanc descendant du signal d'horloge généré.

11. Procédé selon la revendication 9 ou 10, dans lequel il est généré, sur base du signal d'horloge principal, une estampille ou plusieurs estampilles qui sont associées à un ou plusieurs signaux de synchronisation externes et/ou au signal d'horloge généré.

12. Procédé selon la revendication 11, dans lequel un rapport entre un ou plusieurs flancs du signal d'horloge généré et les flancs du signal de synchronisation externe est réglé sur base des estampilles associées à ces signaux.

13. Procédé selon l'une des revendications 1 à 12, dans lequel il est généré, sur base des signaux d'horloge préparés à l'étape (a), une pluralité de signaux d'horloge indépendants.

14. Dispositif pour générer un signal d'horloge (CLKOUT) à propriétés de signal (PERIOD, DUTY, PHASE) prédéterminées, avec :

un générateur de cycles à phases multiples (106) destiné à préparer une pluralité de signaux d'horloge (PCLK[n-1:0]) de fréquence sensiblement identique et chacun de rapports de phase (Φ) différents par rapport à un signal d'horloge principal (CLK) ; et
une unité de superposition de phase (POU) qui sélectionne, sur base d'un signal de commande (PEN) préparé en fonction du signal d'horloge à générer (CLKOUT), des signaux d'horloge prédéterminés à partir de la pluralité de signaux d'horloge (PCLK) préparés et regroupe les signaux d'horloge sélectionnés, pour générer le signal d'horloge (CLKOUT) ;

**caractérisé par le fait**
**que** le signal de commande comporte une pluralité de signaux d'activation (PEN[n-1:0]), un signal d'activation (PEN[]) étant prévu pour chacun de la pluralité de signaux d'horloge (PCLK[]), et les signaux d'activation (PEN[]) étant préparés temporisés, afin de régler un alignement de ces derniers, pour obtenir les propriété de signal d'horloge prédéterminées du signal d'horloge (CLKOUT) à générer.

15. Dispositif selon la revendication 14, avec :

un interpolateur de flanc primaire (PEI ; PEI2) destiné à déterminer une position du flanc d'attaque dans le signal d'horloge à générer ;
un calculateur de flanc secondaire (SEC) destiné à déterminer une position du flanc suivant dans le signal d'horloge à générer, partant de la position du flanc d'attaque ; et
une unité d'activation de phase (FEU), pour générer, sur base de la position du flanc d'attaque et de la position du flanc suivant, une séquence de signaux d'activation.

16. Dispositif selon la revendication 15, dans lequel le signal d'horloge à générer présente un rapport de phase et de fréquence défini par rapport à un signal de synchronisation (SYNC), avec :

une unité de détection de flanc (EDP), pour détecter des variations d'état de signal dans le signal de synchronisation (SYNC), afin de générer un modèle de flanc ;
un décodeur de position de flanc (EPD), destiné à déterminer des flancs à polarité (POL) déterminée dans le modèle de flanc ; et
un calculateur de paramètres de cycle (CPC), destiné à déterminer, sur base des flancs déterminés du signal de synchronisation (SYNC), la période et la phase du signal d'horloge synchronisé à générer.

**17.** Dispositif selon l'une des revendications 14 à 16, dans lequel la période du signal d'horloge généré est modulée, pour obtenir un signal d'horloge à étalement du spectre, avec
un interpolateur à étalement du spectre, destiné à incrémenter, après chaque cycle de signal d'horloge généré, la période d'une valeur prédéterminée, jusqu'à ce que soit atteinte une limite supérieure, et à décrémenter la période d'une valeur prédéterminée, jusqu'à ce que soit atteinte une limite inférieure.

**18.** Dispositif selon l'une des revendications 14 à 17, avec un dispositif (CCC) destiné à générer une estampille ou plusieurs estampilles.

**19.** Dispositif selon la revendication 18, dans lequel le dispositif (CCC) destiné à générer une estampille ou plusieurs estampilles comporte un circuit de calcul de cycle d'horloge (CCC) qui reçoit le cycle d'horloge principal CLK et un compteur de cycle d'horloge principal (MCC), le circuit de calcul de cycle d'horloge (CCC) générant, sur base du signal d'horloge principal, une estampille ou plusieurs estampilles qui sont associées à un ou plusieurs signaux de synchronisation externes (SYNC[]) et/ou au signal d'horloge (CLKOUT) généré.

EP 1 554 803 B1

**100**

**106**

XTAL

**102** — | KRISTALL-OSZIL-LATOR | XCLK | PHASENRE-GELSCHLEIFE (PLL) | CLK | PHASENVER-ZÖGERUNGS-SCHLEIFE (DLL) |

**104**

PCLK[0]  PCLK[1]  PCLK[2]  ...  PCLK[n-3]  PCLK[n-2]  PCLK[n-1]

# FIG. 1

FIG. 2

FIG. 3

EP 1 554 803 B1

FIG. 4

INVCLK = 0

FIG. 5

FIG. 6

PEI

FIG.7

EP 1 554 803 B1

FIG. 8

FIG. 9

EP 1 554 803 B1

CLK

PCLK[0:n-1]

INIT

PERIOD

DUTY

| PRIMÄRER FLANKEN-INTERPOLATOR | | SEKUNÄRER FLAN-KENBERECHNER | | PHASENAKTIVIE-RUNGSEINHEIT | PHASENVER-LAGERUNGSEINHEIT |
|---|---|---|---|---|---|
| | CNT | | LEAD | | |
| | EDGE | | TRAIL | | |
| | T_EDGE | | P_LEAD | | |
| | T_LEN | | P_TRAIL | | |
| PEI | | SEC | | PEU | POU |

PEN

CLKOUT

INVCLK

CGU

FIG. 10

FIG. 11

EP 1 554 803 B1

FIG. 12

FIG. 13

FIG. 14

FIG. 15

FIG. 16

FIG. 17

FIG. 18

FIG. 19

FIG. 20

43

FIG. 21

EP 1 554 803 B1

VERZÖGERUNGS-
STEUERUNGSLEITUNG
LEISTUNGSSCHIENEN

LEITUNGEN MIT MULTI-PHASEN-TAKTSIGNAL

DIGITALE
SCHALTUNG

POU → FREI LAUFENDER TAKT #1

CLK→ DLL ～106

DIGITALE
SCHALTUNG

POU → FREI LAUFENDER TAKT #2

DIGITALE
SCHALTUNG

POU → SYNCHRONISCHER TAKT

EDU ← SYNCHRONISATIONSSIGNAL

WIEDERGEWINNUNGSEINHEIT (RU)

DIGITALE
SCHALTUNG

POU → FREI LAUFENDER TAKT #3

FIG. 22